# EUROPEAN PATENT SPECIFICATION

(11) **EP 1 861 880 B1**
(45) Date of publication and mention of the grant of the patent: **20.06.2012**
(21) Application number: 06730735.5
(22) Date of filing: 24.03.2006
(51) Int. Cl.: H01L 27/14, H01L 23/10

(54) **METHOD OF MANUFACTURING SOLID STATE IMAGING DEVICE**
VERFAHREN ZUR HERSTELLUNG EINES HALBLEITER-BILDGEBUNGSBAUELEMENTS
PROCEDE DE FABRICATION DE DISPOSITIF D IMAGERIE A SEMI-CONDUCTEURS

(30) Priority: 25.03.2005 JP 2005087969
(43) Date of publication of application: 05.12.2007
(73) Proprietor: FUJIFILM Corporation, Minato-ku Tokyo 106-8620 (JP)
(72) Inventor: NISHIDA, Kazuhiro c/o FUJIFILM Corporation,, Kanagawa, 250-0193 (JP); SHIMAMURA, Hitoshi c/o Fujifilm Microdevices Co., Ltd.,, Kurokawa-gun, Miyagi, (JP); TAKASAKI, Kosuke c/o FUJIFILM Corporation,, Kanagawa 250-0193 (JP)
(74) Representative: Klunker . Schmitt-Nilson . Hirsch
(86) International application number: PCT/JP2006/306787
(87) International publication number: WO 2006/101274

(56) References cited:
- EP-A1- 1 493 766
- EP-A2- 0 647 967
- EP-A2- 1 445 803
- EP-A2- 1 445 803
- JP-A- 02 203 561
- JP-A- 02 203 561
- JP-A- 09 055 445
- JP-A- 09 055 445
- JP-A- 10 340 914
- JP-A- 2003 212 963
- JP-A- 2004 363 400
- JP-A- 2004 363 400
- US-A1- 2004 016 886
- US-A1- 2004 061 799
- US-A1- 2004 159 920
- US-A1- 2004 159 920
- US-A1- 2004 180 472
- US-A1- 2004 188 699
- US-A1- 2005 059 188

## Description

### Technical Field

The present invention relates to a method of manufacturing solid state imaging devices.

### Background Art

Digital cameras and video cameras with a solid state imaging device of either CCD type or CMOS type are in widespread use. Often, the solid state imaging device, together with a memory device , is incorporated in electrical equipments such as personal computers, mobile phones, and personal digital assistances to provide them with an image capturing function. An increasing demand for the solid state imaging devices is downsizing so that it does not affect the size of the electrical equipments greatly.

Solid state imaging device of chip scale package type (hereinafter "CSP") are known in the art. The CSP type solid state imaging device is composed of, for example, an imaging chip provided with both an image sensor (such as CCD) and input/output pads on the upper surface, a cover glass (i.e. cover) attached on the upper surface of the imaging chip through a spacer for sealing the imaging sensor, and external electrodes for connection to external devices. The CSP type solid state imaging device is packaged in approximately the size of the imaging chip, which is very small (see, for example, the Japanese patent laid-open publication No. 2001-257334).

Generally, the CSP type solid state imaging device is made in the following procedure:
1. forming a plurality of the image sensors (each with a photoelectric conversion section and a charge transfer section) and the corresponding input/output pads on the upper surface of a silicon wafer.
2. forming the spacers atop of the silicon wafer to enclose the image sensors individually.
3. attaching a glass substrate, i.e. a base material of the cover glass, to the silicon wafer through the spacer to seal each of the image sensors.
4. forming on the silicon wafer the external electrodes that correspond to the image sensors.
5. dicing the silicon wafer and the glass substrate into individual image sensors.

Since the CSP type solid state imaging device is as small as the imaging chip, the external electrodes are usually formed on the lower surface of the imaging chip. Therefore, with the conventional technique, the external electrodes on the lower surface are connected respectively to the input/output pads on the upper face of the image sensor in a forming process of the external electrodes. Concretely, they are connected either by through wirings that pass through the imaging chip or side wirings formed on the side faces of the imaging chip.

The external electrode with the through wiring may be formed in the following procedure (see, for example, "Press release, a next generation packaging method with a through electrode on a semiconductor chip is established at practical level" from Association of Super-Advanced Electronics Technologies, searched on February 15, 2005, via the Internet, <URL:http://www.aset.or.jp/press-release/si_20 040218/si_20040218.html>):
1. forming the through holes on the silicon wafer to extend from the lower surface to the input/output pads.
2. forming insulating thin layer on the inner walls of the through holes.
3. forming the through wirings of copper plate in the through holes.
4. forming, on the lower surface of the silicon wafer, secondary wirings to be connected with the through wirings.
5. forming solder balls on the secondary wirings.

On the other hand, the external electrode with the side wiring may be formed in the following procedure (see, for example, the U.S. Patent No. 6,777,767 B2):
1. attaching a reinforcing board to the lower surface of the silicon wafer.
2. forming secondary wirings on the lower surface of the reinforcing board.
3. forming cutouts, which pass through between the lower surface of the reinforcing board and the input/output pads, at the portions that would become the side faces of the solid state imaging device.
4. forming conductive films inside the cutouts to connect the input/output pads and the secondary wirings.
5. forming solder balls on the secondary wirings.

When the silicon wafer is diced, the conductive films appear on the side faces of the solid state imaging device and become the side wirings.

Forming of the above through wirings requires a large number of processes, such as etching, film formation, and plating. Moreover, certain dedicated machines (for example, the etcher, the CVD machine, the plating machine) are required, which will raise the cost. Also required is much time for listing and evaluating the conditions, such as the shape of the through hole, the thickness of the insulating film and a conductive paste and so force, in order to ensure a certain level of the electric property and the reliability.

For the same reason, forming of the side wirings also raises the cost. Moreover, the side wirings cause to enlarge the solid state imaging device because the input/output pads have to be spaced at no less than 350 µm interval for the wires passing through the side faces to the lower surface. When it is enlarged, fewer solid state imaging devices can be produced from a single silicon wafer and the cost will be raised.

The Japanese patent laid-open publication No. 2001-257334 discloses a packaging method of the CSP type solid state imaging device. This method begins by fixing a sensor package (composed of an imaging chip and its cover glass) without external electrodes onto a circuit board. Then, input/output pads of the sensor package and conductive pads of the circuit board are joined by bonding wires. Finally, the periphery of the sensor package is sealed with sealing resin. This packaging method enables to use the conventional post-process technique and facilities for semiconductor devices.

Although it becomes somewhat large, this kind of resin sealed package enables to produce the reliable solid state imaging devices at low cost, and solve the above mentioned drawbacks of the through wirings and the side wirings as well. In addition, the sealing resin seals a cavity enclosed by the imaging chip, the spacer, and cover glass, preventing electrical problems in the image sensor.

However, the Japanese patent laid-open publication No. 2001-257334 is silent about how to protect the upper face of the cover glass in the sealing process. If the upper face of the cover glass is overlaid, stained, or damaged by the resin, the yield is decreased and the cost is raised. Therefore, a development of an effective resin sealing method able to protect the upper surface of the cover glass is highly demanded.

Despite the fact that the moisture absorption of the sealing resin causes various problems to the solid state imaging devices as described above, the Japanese patent laid-open publication No. 2001-257334 is silent about a solution to the moisture related problems. Therefore, a proper countermeasure to the moisture of the solid state imaging devices is highly demanded.

In the meanwhile, one of the interests of the art is a so-called "system-in-package" (hereinafter "SIP"), which packs a plurality of IC chips, normally mounted separate on the circuit board, into a single package as a system. For the SIP of a CPU and memories, there is no need to expose the IC chips. In contrast, when the above sensor package is packed in the SIP, the cover glass has to be exposed and, therefore, care must be taken for arrangement of the sensor package.

If this problem occurs in the solid state imaging device of the Japanese patent laid-open publication No. 2001-257334, the cracks or the peeling off of the sealing resin lead to remove the bonding wires connected to the input/output pads and the conductive pads. At the end, the solid state imaging device becomes inoperative. In addition, the moisture in the sealing resin dissolves ionic impurities out of the sealing resin, and an electrochemical decomposition reaction is thereby stimulated to possibly corrode the aluminum-made input/output pads. Furthermore, when the sealing resin peels off from the sensor package or the circuit board, the spacer and the cover glass may also come off , along with the sealing resin, from the imaging chip. This will cause other problems, such as fog on the cover glass and electrical malfunctions of the image sensor.

Despite the fact that the moisture absorption of the sealing resin causes various problems to the solid state imaging devices as described above, the Japanese patent laid-open publication No. 2001-257334 is silent about a solution to the moisture related problems. Therefore, a proper countermeasure to the moisture of the solid state imaging devices is highly demanded.

A method of manufacturing solid state imaging devices according to the preamble of claim 1 is known from EP 1 445 803 A2.

US 2004/188699 A1 discloses a method of manufacturing a semiconductor device in which a translucent cover layer is provided on the surface of the optical semiconductor element.

In view of the above, an object of the present invention is to provide the manufacturing method of the solid state imaging device that enables to seal the sensor package with resin while effectively protecting the cover glass of the image sensor. This manufacturing method of the solid state imaging device can also prevent negative effects of moisture.

### Disclosure of Invention

In order to achieve the above and other objects, a manufacturing method of solid state imaging devices according to the present invention includes the steps of claim1.

According to the above manufacturing method, the mask protects the upper face of the cover and also absorbs the difference in height between the sensor packages in the protection step, and prevents the sealing resin to stick onto the cover. It is therefore possible to prevent the decrease in yield resulted from the stain of the cover caused by the sealing resin. Furthermore, the solid state imaging device except for the cover glass can be properly sealed. In addition, a plurality of solid state imaging devices can be manufactured at one time, and the cost will be reduced.

When the sensor package and at least one cooperating chip are adhered on the circuit assembly board to form a system-in-package, they are adhered such that the upper face of the cover is not hidden by the cooperating chip. Then the circuit assembly board is sealed while the upper mold die makes tight contact with the upper face of the cover to keep it off from the sealing resin. In this way, even for the SIP, the decrease in yield will also be prevented and the solid state imaging device can be properly sealed except for the cover glass. In addition, a plurality of solid state imaging devices in SIP can be manufactured at one time, and the cost will be reduced.

The mask may include mask sections to overcoat the upper surfaces of each cover, and an outer wall which surrounds the periphery of the circuit assembly board to define the print area of the sealing resin. Since the area for the vacuum screen printing is thereby decided, an unnecessary use of the sealing resin will be prevented

The mask may be a protection sheet that is approximately the same shape as, and larger than a light receiving surface of the image sensor, but is smaller than the upper face of the cover. The protection sheet is adhered to the cover such that an edge of the protection sheet stays at between the edges of the light receiving surface of the image sensor and the upper face of said cover.

If the edge of the protection sheet juts outside the cover glass, it may possibly bend and get into the sealing resin in the vacuum screen printing operation. Such protection sheet will leave a dent in the sealing resin when detached from the cover glass, and the sealing performance as well as appearance of the product is degraded. Since the protection sheet is arranged to stay within the upper face of the cover glass in the present invention, the foregoing problem will never occur(s). In addition, the protection sheet does not impair the performance of image sensor because it is larger than the light receiving surface of the image sensor. It is preferable to use an enclosing frame when the protection sheet is used.

The vacuum screen printing operation includes a first printing step for screen printing the sealing resin around the sensor packages under a first air pressure which is less than atmospheric pressure and a second printing step for screen printing the sealing resin again around the sensor packages under a second air pressure which is greater than the first air pressure but less than the atmospheric pressure. With these steps, it is possible to seal the periphery of each sensor package properly without having air bubbles or the like inside the sealing resin. Preferably, the first air pressure is 100Pa(s), and the second air pressure is 20000Pas to 90000Pa(s).

Alternatively, in an example not forming part of the claimed invention the sensor package may be sealed with the sealing resin through a potting process. Preferably provided before the potting process is a formation process of a retaining wall, which encloses the periphery of the circuit assembly board to keep the sealing resin inside thereof. This sealing method composed of the potting process and the retaining wall formation step can be also used to manufacture the solid state imaging devices of system-in-package (SIP).

The retaining wall may be formed with a dam material mounded around the circuit assembly board. The dam material is preferably made from the same raw material as the sealing resin, so that it does not have cracks on the boundary to the sealing resin. In order to prevent the cracks resulted from the difference in thermal expansion, the dam material may preferably have the thermal expansion coefficient of no more than 13ppm/° C. Additionally, for better workability in the retaining wall formation process, the dam material may preferably have a viscosity of approximately 500Pas. The retaining wall made of such dam material will barely increase the number of process if it is cured along with the sealing resin in the mold curing process.

To adhere the sensor packages to the circuit assembly board, sheets of die attach material are used in a example not forming part of the claimed invention. If the die attach material is paste or liquid and the thickness of coating is not accurately controlled, the cover glass are not level with each other on the circuit assembly board. This may result to create a gap between the mask and the cover glass, and the cover glass will be stained by the sealing resin. On the other hand, the sheet of die attach material has uniform thickness. Since the covers are level with each other on the circuit assembly board, the upper face thereof will be surely protected. Therefore, it is prevented that the sealing resin stains the cover to decrease the yield.

In an example not forming part of the claimed invention it is preferable that the die attach material has glass transition temperature lower than the heat curing temperature in the mold curing step. Such die attach material reaches the glass transition temperature with a low heat temperature at the beginning of the mold curing step, and serves to eliminate the difference in thermal expansion coefficient between the imaging chip and the circuit assembly board. The sealing resin is therefore kept from the cracks and resultant peeling off. Preferably, the die attach material has a glass transition temperature of 50° C to 80° C, and a thermal expansion coefficient of 80 to 100ppm/°C.

An adhesive agent, for attachment of the imaging chip and the cover glass, may have the glass transition temperature higher than the heat curing temperature in the mold curing step, so that it does not reach the glass transition temperature to lose the adhesion force during the mold curing step. Nonetheless, the adhesive agent may have a relatively low glass transition temperature if the sealing resin has low thermal expansion coefficient and therefore gives less thermal stress on the adhesive agent at high temperature.

In an example not forming part of the claimed invention the circuit assembly board may be a substrate board, and the external electrode may be either a solder ball or solder paste. The substrate board and the solder ball or paste are both reliable and cheap, and will serve for high yield and cost reduction.

Rather, the circuit assembly board may be a lead frame. In this case, outer leads of the lead frame are plated in the external electrode formation step. The lead frame is also reliable and cheap, and able to serve for high yield and cost reduction. It should be noted that the plating operation can be omitted if the lead frame is a PPF (Pre-plated Frame).

Furthermore, the circuit assembly board may be a tape substrate. In this case, if the tape substrate is made of a super heat resistant polyimide film, which drains moisture from the sealing resin, prevention of the steam explosion can be expected.

In an example not forming part of the claimed invention between the die bonding step and the wire bonding step, a cleaning step may be provided for the sensor package, the cooperating chips, and the circuit assembly board. This cleaning step improves the adhesion of the sealing resin to the sensor package, and will improve reliability of the solid state imaging device. The method of cleaning may preferably be an UV cleaning or a plasma cleaning.

In an example not forming part of the claimed invention in order to prevent the cracks or the peeling off of the sealing resin from the sensor package and the circuit board, the sealing resin may preferably be high adhesion resin, which has excellent adhesion to the sensor package, the cooperating chips, and the circuit assembly board. The high adhesion resin will be, for example, bisphenol type epoxy resin. Note that an amine or polyamine curative agent is suitably added to this resin.

In an example not forming part of the claimed invention in view of workability and anti-void function, the sealing resin has a viscosity of preferably no more than 100Pa. If the sealing resin is one that decreases its viscosity on the application of heat, it is preferably heated at the time of use.

In an example not forming part of the claimed invention the thermal expansion coefficient of the sealing resin is 12ppm/°C and below, so that thermal stress can be reduced between the sensor package and the circuit board. From the same reason, the sealing resin preferably has a flexural modulus of 28Gpa and below, and a mold shrinkage factor of 0.12% and below.

In an example not forming part of the claimed invention since the cracks and the peeling off are more likely to occur as the trapped moisture increases in the sealing resin, a water absorption coefficient of the sealing resin is preferably 0.3% by weight and below, more preferably 0.15% by and below.

In an example not forming part of the claimed invention in addition, for more reduction of the water absorption coefficient, the sealing resin may have a ratio of the filler material of no less than 80%. To achieve this filler ratio, it is preferable to constitute the filler material for the sealing resin with a first filler and a second filler smaller in size than the first filler.

In an example not forming part of the claimed invention preferably, the glass transition temperature of the sealing resin is 150°C and above to create a proper temperature cycle.

In an example not forming part of the claimed invention furthermore, to ensure a proper level of strength in the solid state imaging device and prevent deformation thereof , the sealing resin should have a hardness of 90 shore D and above.

In an example not forming part of the claimed invention in order to prevent the corrosion of the input/output pads caused by the melting impurities out of the sealing resin, the sealing resin may preferably have a halogen or alkali contents of no more than 10ppm respectively.

According to the present invention, it is possible to take the advantage of the CSP type solid state imaging device that it is small and to overcome the drawbacks of the through wirings and the side wirings, such as a high cost of manufacture, low reliability, and growth in chip size. Since the upper face of the cover for the sensor package will never be stained or damaged, the decrease of the yield is prevented and so does the rise in the price of the solid state imaging device. Additionally, it is possible to manufacture reliable system-in-packages having the CSP type solid state imaging device at low cost.

The various modifications made in the present invention can be used separately or in combination to become an effective countermeasure to the problems caused by the moisture absorption of the sealing resin, such as the cracks, peeling off of the elements, and inoperation of the device.

### Brief Description of Drawings

FIG. 1 is a perspective view of a solid state imaging device made according an example being useful to understand the present invention ;
FIG.2 is a cross sectional view of the solid state imaging device;
FIG.3 is a flow chart of a manufacturing process for the solid state imaging device;
FIG.4 is a flow chart of a manufacturing process for a sensor package;
FIG.5 is an explanatory view illustrating formation of a spacer of the sensor package;
FIG.6 is an explanatory view illustrating attachment operation of substrates and dicing operation of the solid state imaging device;
FIG.7 is a perspective view of a glass substrate and a silicon wafer;
FIG.8 is an explanatory view illustrating the manufacturing process of the solid state imaging device;
FIG.9 is a perspective view of a circuit assembly board;
FIG. 10 is a schematic view of a vacuum screen printing machine;
FIG.11 is a plane view of a stage;
FIG.12 is a perspective view of the circuit assembly board with a mask attached thereon;
FIG.13 is a flow chart of a sealing process according to the present invention;
FIG.14 is an explanatory view illustrating a process of vacuum screen printing according to the present invention;
FIG.15 is a cross section view illustrating a cover glass covered by a protection sheet;
FIG.16 is a perspective view of the solid state imaging device in a FBGA package;
FIG.17 is a cross section view of the solid state imaging device in the FBGA package;

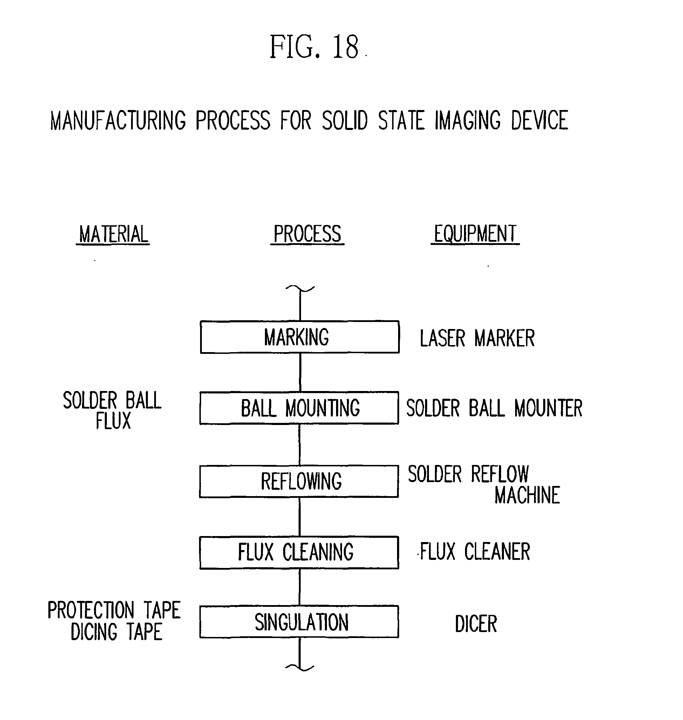

FIG.18 is a flow chart of a procedure for manufacturing the solid state imaging device in the FBGA package;
FIG.19 is a perspective view of the solid state imaging device in a QFN package;
FIG.20 is a cross section view of the solid state imaging device in the QFN package;
FIG.21 is a flow chart of a procedure for manufacturing the solid state imaging device in the QFN package;
FIG.22 is a perspective view of the solid state imaging device in a system in package;
FIG.23 is a cross section view of the solid state imaging device in a stacked system in package;
FIG.24 is a flow chart of procedure for a potting process;
FIG.25 is a schematic view of the procedure for the potting process;
FIG.26 is a cross sectional view of the solid state imaging device sealed with resin through the potting process;
FIG.27 is a cross sectional view of the solid state imaging device provided with a chamfered section on the outer edge of the cover glass;
FIG.28 is a cross sectional view of the solid state imaging device provided with a step section on the outer edge of the cover glass;
FIG.29 is a cross sectional view of the solid state imaging device with rough surfaces shaped on the side faces of the cover glass, spacer, and the imaging chip;
FIG.30 is a cross sectional view of the solid state imaging device with polyimide films formed on the side faces of the cover glass, spacer, and the imaging chip;
FIG.31 is a cross sectional view of the solid state imaging device with nitride films formed on the side faces of the cover glass, spacer, and the imaging chip;
FIG.32 is a cross sectional view of the solid state imaging device with an inactive gas filled in a cavity enclosed by the cover glass, spacer, and the imaging chip;
FIG.33 is a flow chart of a manufacturing process including an UV cleaning or plasma cleaning step;
FIG.34 is a cross sectional view of the solid state imaging device, in which the circuit board is a tape substrate made of a super heat resistant polyimide film; and
FIG.35 is an explanatory view of fillers contained in the sealing resin.

### Best Mode for Carrying Out the Invention

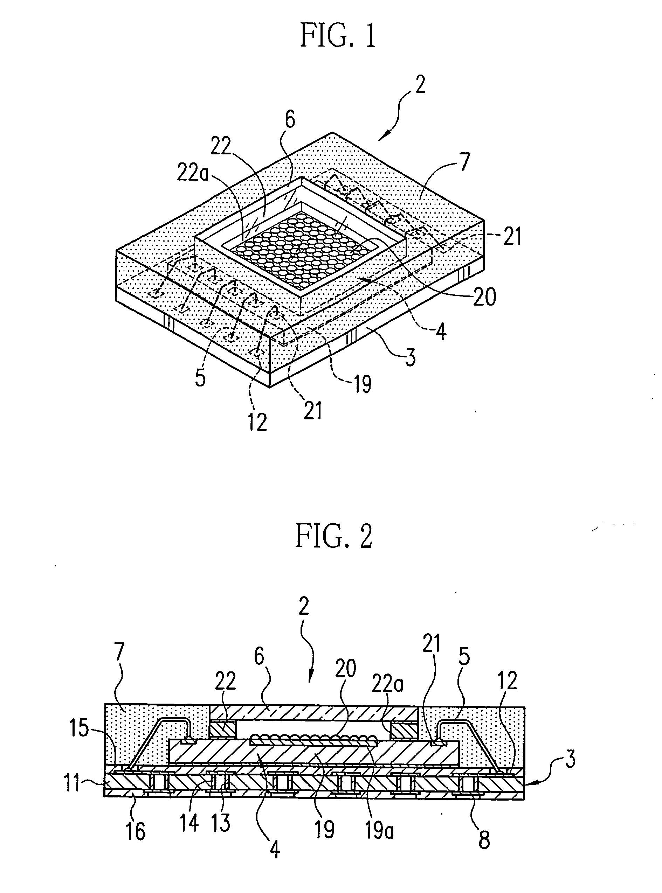

Referring now to FIG.1 and FIG.2, a solid state imaging device 2 of a first example being useful to understand the present invention includes a rectangular circuit board 3, a sensor package 4 fixed onto the circuit board 3, a plurality of bonding wires 5 for connection between the circuit board 3 and the sensor package 4, sealing resin 7 that seals a periphery of a cover glass 6 of the sensor package 4, and external conductive pads 8 formed on the lower surface of the circuit board 3. The solid state imaging device 2 is in a package so called "Fine Pitch Land Grid Array (FLGA)". The FLGA package is prevalent in the art, and it is possible to manufacture reliable solid state imaging devices 2 at low cost.

The circuit board 3 is a substrate board (or printed board) fabricated from a base 11 of glass epoxy or the like. On a top surface of the base 11, a plurality of internal conductive pads 12, i.e. internal electrodes, are formed for connection with the sensor package 4 through the bonding wires 5. Formed on an under surface of the base 11 are the external conductive pads 8, i.e. external electrodes. These internal and external conductive pads 12 and 8 are made of, for example, copper (Cu) and electrically connected to each other by conductive films 14 formed in through holes 13 which run through the base 11. The top and under surfaces of the base 11 are covered with solder resists 15 and 16 except where the internal and the external conductive pads 12 and 8 occupy.

The sensor package 4 is composed of an imaging chip 19 of rectangular shape, an image sensor 19a such as CCD or CMOS provided on the upper surface of the imaging chip 19, a microlens array 20 attached on the imaging sensor 19a, a plurality of input/output pads 21 connected to the circuit board 3 through the bonding wires 5, the translucent cover glass 6 for sealing the image sensor 19a from above, and a spacer 22 held between the imaging chip 19 and the cover glass 6.

The imaging chip 19 is made by dividing a silicon wafer, on which a plurality of image sensors 19a and input/output pads 21 are arranged in matrix, into rectangular pieces. Each image sensor 19a includes a plurality of matrix arranged light receiving elements (photodiodes), on which a color filter (not shown) of RGB and a microlens 20 are overlaid. The input/output pads 21 are aligned along the two opposite sides across the image sensor 19a. The input/output pads 21 are, for example, gold (Au) or aluminum (Al) print and connected to the image sensor 19a through wirings, which are made of the same material and the same method as the input/output pad 21.

The spacer 22 is made of an inorganic material such as silicon, and has a frame shape with an opening 22a in the middle. The spacer 22 is attached to the upper surface of the imaging chip 19 such that it can surround the image sensor 19a to create a gap between the microlens array 20 and the cover glass 6. It is thereby prevented the physical contact of the microlens array 20 and the cover glass 6.

The cover glass 6 is low alpha ray emission glass and attached onto the spacer 22 such that it covers the opening 22a. The low alpha ray emission glass, which emits little alpha rays, can prevent the alpha rays to destruct the light receiving elements of the image sensor 19a. Additionally, an infrared cut filter and an optical low pass filter may be attached on the cover glass 6.

The sensor package 4 is die bonded onto the circuit board 3. The bonding wires 5 for connection between the input/output pads 21 and the internal conductive pads 12 may be made of Au or Al. The sealing resin 7 for sealing the periphery of the cover glass 6 is, for example, a thermosetting resin of epoxy that is conventionally used for the seal of ICs. The sealing resin 7 keeps the input/output pads 21, the internal conductive pads 12, and bonding wires 5 from the moisture and oxygen that will cause oxidization and corrosion. Also, the sealing resin 7 can improve the mechanical strength of the solid state imaging device 2.

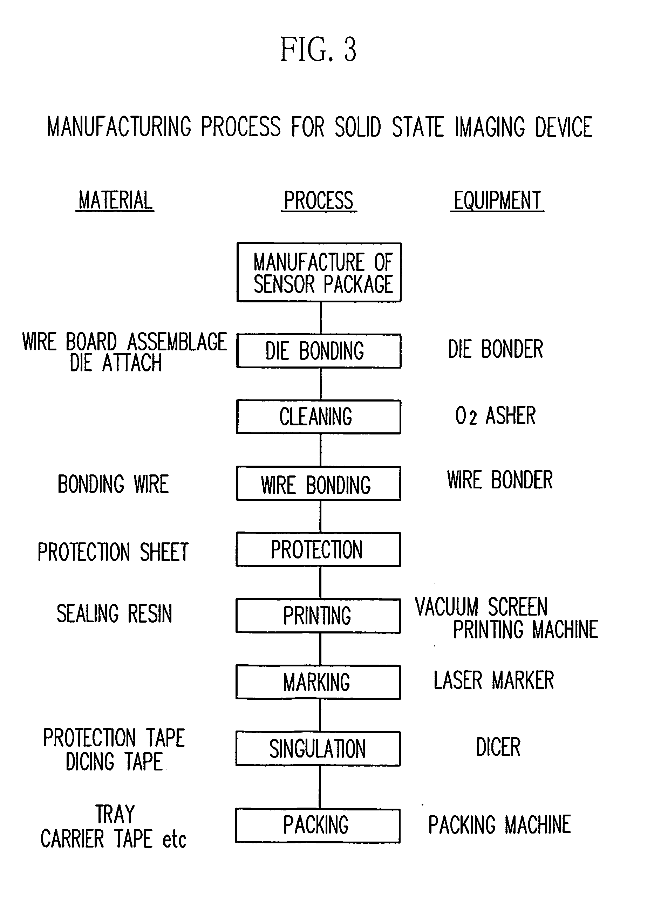

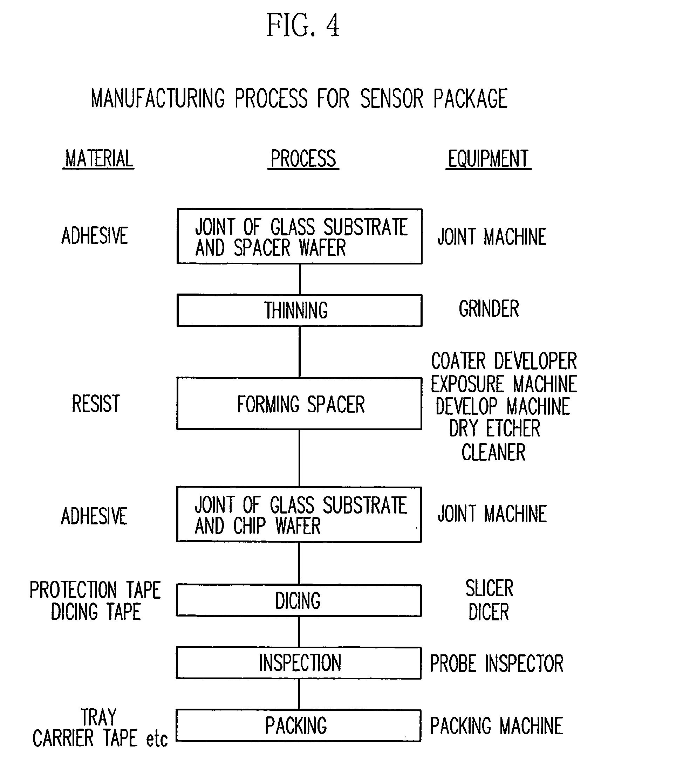

Next, the manufacturing process for the solid state imaging device 2 is described with reference to the flow charts of FIG.3 and FIG.4. Note that each flow chart has lists, on both sides, of the materials and equipments used in each step of the process. The first step of the manufacturing process for the solid state imaging device 2 is the manufacture of the sensor package 4.

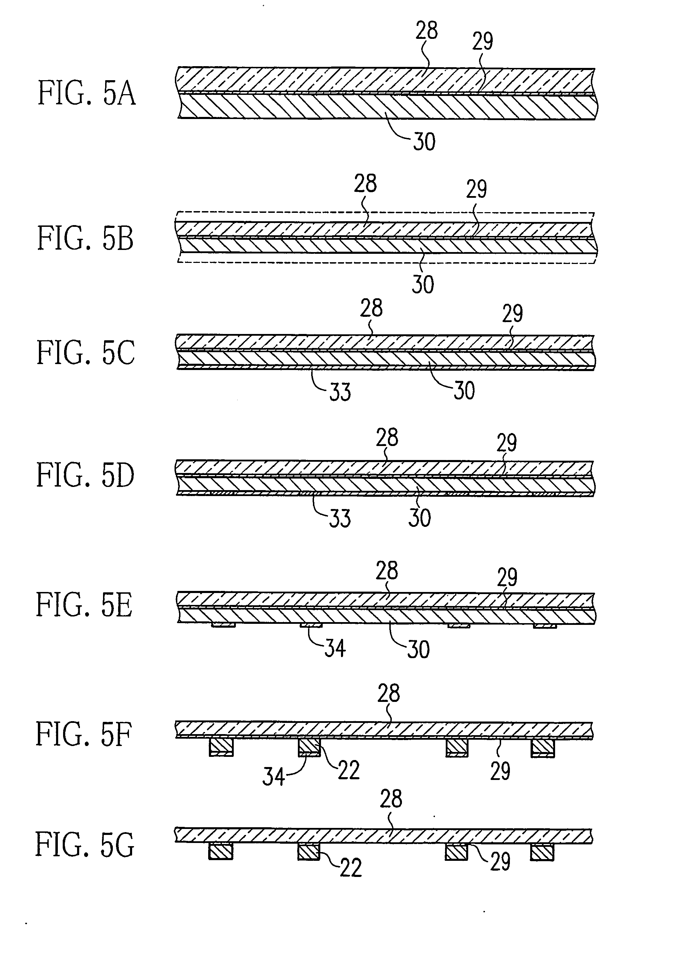

The manufacture of the sensor package 4 begins by attaching a glass substrate 28, i.e. a base material of the cover glass 6, to a spacer wafer 30, i.e. a base material of the spacer 22. As shown in FIG.5A, an adhesive 29 is applied on the under surface of the glass substrate 28 with using a bar coater, blade coater, a spin coater, or such. Then, the spacer wafer 30 is attached underneath the glass substrate 28 with using a joint machine that can hold and move the glass substrate 28 and spacer wafer 30 parallel to each other. Although the adhesive 29 is typically a room temperature curing adhesive, it is possible to use any of UV curable adhesive, visible light curable adhesive, or heat curing adhesive. In addition, the attachment may be done under a vacuum state so that air does not enter in between the glass substrate 28 and the spacer wafer 30 at the time of the attachment.

As shown in FIG.5B, the glass substrate 28 and the spacer wafer 30 are made thinner. To facilitate the handling in attachment operation and to reduce the cost, the glass substrate 28 and the spacer wafer 30 are initially made with a standard, somewhat thick, materials. Therefore, they are made thinner to allow the minimization of the solid state imaging device 2 and time reduction in etching work. Used in this thinning work is, for example, a grinding and polishing machine.

Subsequently, the spacer 22 is formed. As shown in FIG.5C, a resist 33 is applied on the under surface of the spacer wafer 33. Then, as shown in FIG.5D, the resist 33 is exposed and developed with using a predetermined mask, and thereby a resist mask 34 in the shape of the spacer 22 is formed as shown in FIG.5E. To form the resist mask 34, a coater developer, an exposure machine, and a developing machine are used.

The spacer wafer 30 with the resist mask 34 is etched by a dry etcher and, as shown in FIG.5F, unmasked areas are removed and a plurality of spacers 22 are created underneath the glass substrate 28. After etching, the resist mask 34 and the adhesive 29 are removed, as shown in FIG.5G, with using a cleaning machine.

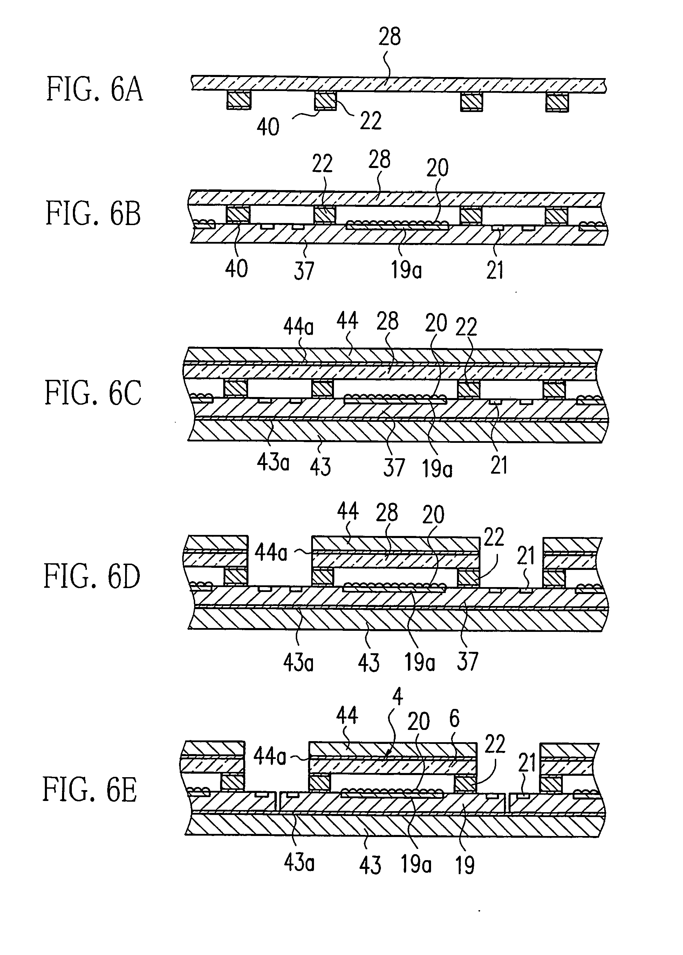

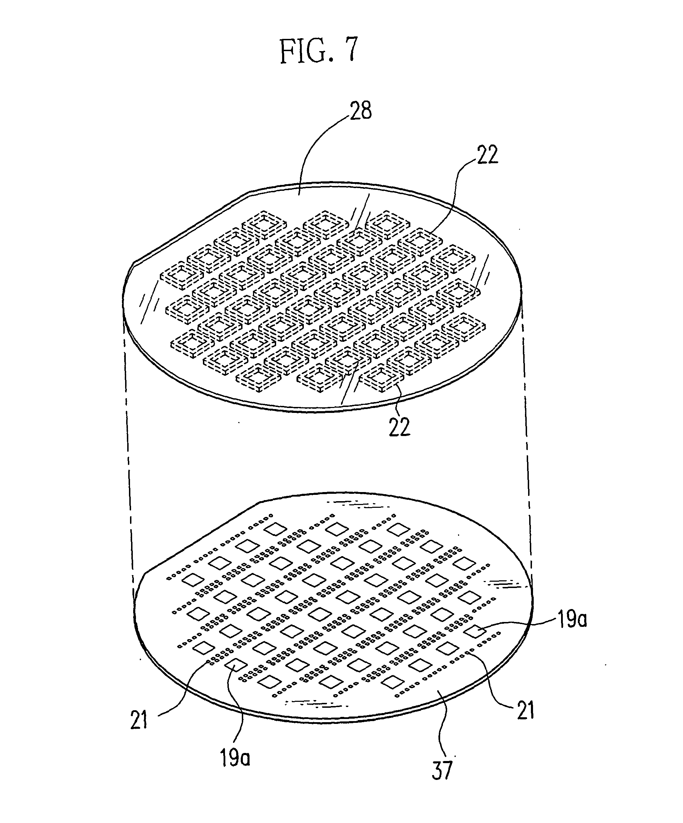

The glass substrate 28 with the spacers 22 thus created is attached to a silicon wafer 37, which has a plurality of image sensors 19a and input/output pads 21 formed thereon as shown in FIG.7. Firstly, as shown in FIG.6A, adhesives 40 are applied on the spacers 22. The adhesive 40 is typically a room temperature curing adhesive, but it is possible to use any of UV curable adhesive, visible light curable adhesive, or heat curing adhesive.

Then, as shown in FIG.6B, the spacers 22 underneath the glass substrate 28 are attached to the silicon wafer 37. Since this attachment requires an accurate alignment between each image sensor 19a and spacer 22, a joint machine for this operation must have an alignment function to adjust the parallel relationship and horizontal relative positions between the image sensor 19a and the spacers 22. Each image sensor 19a on the silicon wafer 37 is sealed with the spacer 22 and the glass substrate 28, and will be kept free of dusts or shards generated in the subsequent step of the process.

The glass substrate 28 is then diced, together with the silicon wafer 37, into individual image sensors 19a. Firstly, as shown in FIG.6C, the silicon wafer 37 is fixed on an adhesive layer 43a of a dicing tape 43, and a protection tape 44 with an adhesive layer 44a is adhered on the glass substrate 28.

Then, as shown in FIG.6D, the glass substrate 28 is diced along the edges of the spacers 22 with using a slicer. Finally, the silicone wafer 37 is diced into individual image sensors 19a, as shown in FIG.6E, with using a dicer. In this manner, a plurality of the sensor packages 4 is formed at one time. For the protection of the cover glass 6 during shipment, the protection tape 44 may be left adhered. Alternatively, the protection tape 44 should be adhered on each cover glass 6 after dicing if not needed in the dicing operation.

The sensor packages 4 are separately inspected for performance by, for example, a probe inspection machine and only those passed this performance inspection will be detached from the dicing tape 43 and placed individually on trays or attached to a carrier tape for shipment. Alternatively, a plurality of the sensor packages 4 can be left attached to the dicing tape 43 and shipped.

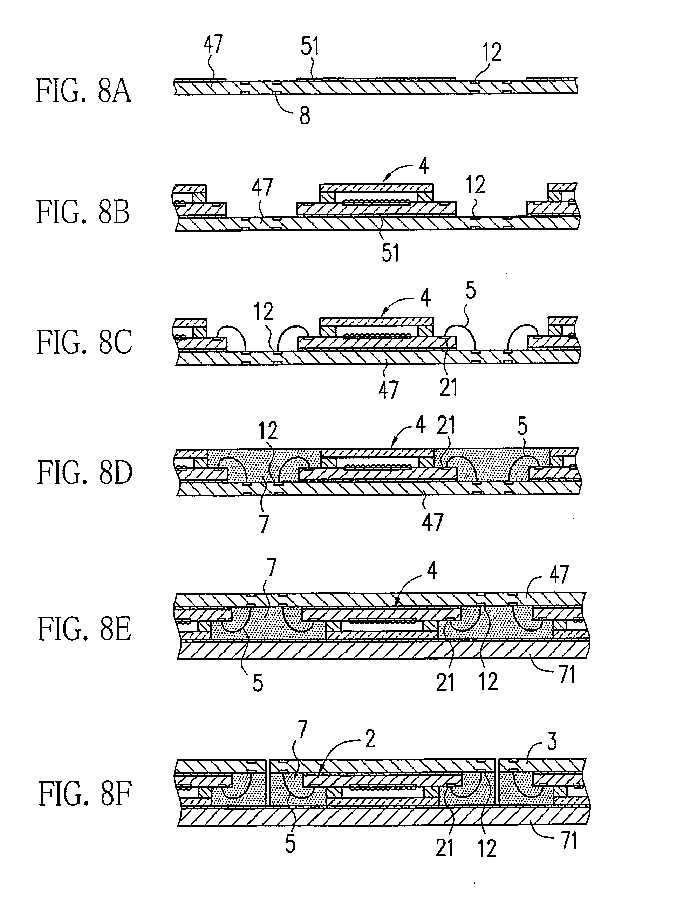

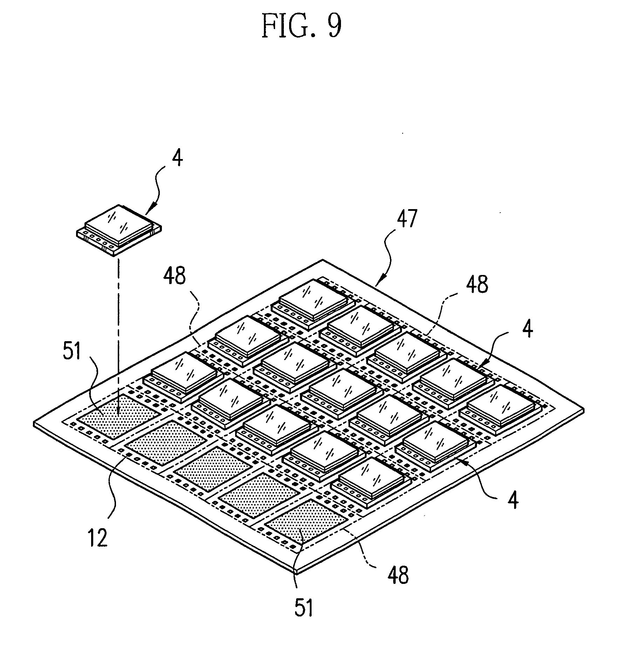

As shown in FIG.3, the manufactured sensor packages 4 are die bonded onto a circuit assembly board 47, a large board with several circuit patterns of same kind. As shown in FIG.8A and FIG.9, the circuit assembly board 47 may be made from, for example, a glass epoxy substrate into a rectangular shape and is provided thereon with twenty, matrix arranged die bonding areas 48, on which the sensor packages 4 are die bonded individually. Each die bonding area 48 previously includes the internal conductive pads 12, the external conductive pads 8, and some others. Note that the number of the die bonding areas 48 is not limited to twenty and may be more or less.

A die bonder for this die bonding operation firstly applies die attach films 51 on the die bonding areas 48 of the circuit assembly board 47. Then, as shown in FIG.8B, the die bonder places the sensor packages 4 on each of the die attach films 51. The circuit assembly board 47 with the sensor packages 4 attached thereon is heated in a heating machine such as an oven, and the die attach films 51 become hardened. Thereby, the sensor packages 4 are fixed to the circuit assembly board 47.

If a paste or liquid of die attach material is to be used, the thickness of coating must be accurately controlled, or otherwise the upper faces of the cover glasses 6 are not level with each other on the circuit assembly board 47. If not level, some of the cover glasses 6 are not protected appropriately in the sealing process and may be stained with the sealing resin 7. In contrast, when the die attach film 51 is used as the die attach material, the upper faces of the cover glasses 6 are almost level with each other because the die attach film 51 has a uniform thickness. Since the upper face of the cover glass 6 is surely protected, it is possible to prevent the sealing resin 7 to stain the cover glass, which leads to decrease the yield. The die attach films 51 may be previously adhered to the sensor packages 4. Additionally, a paste of die attach material can be used if the cover glasses 6 can be level with each other.

In the next cleaning step, the sensor packages 4 and the circuit assembly board 47 are cleaned with using, for example, an O₂ asher. This cleaning step is performed to improve the adhesion of both the bonding wires and the sealing resin in the subsequent wire bonding step and sealing step.

In the next wire bonding step, the input/output pads 21 of each sensor package 4 are connected to the internal conductive pads 12 of the die bonding areas 48 through the bonding wires 5, as shown in FIG.8C. It is preferable in this wire bonding step to form a low loop of the bonding wire 5 so that it will stay below the cover glass 6.

Afterward, as shown in FIG.8D, the upper surface of the circuit assembly board 47 and the peripheries of the sensor packages 4 are sealed with the sealing resin 7. This sealing step includes an actual sealing operation and a protection operation to protect the upper face of each cover glass 6.

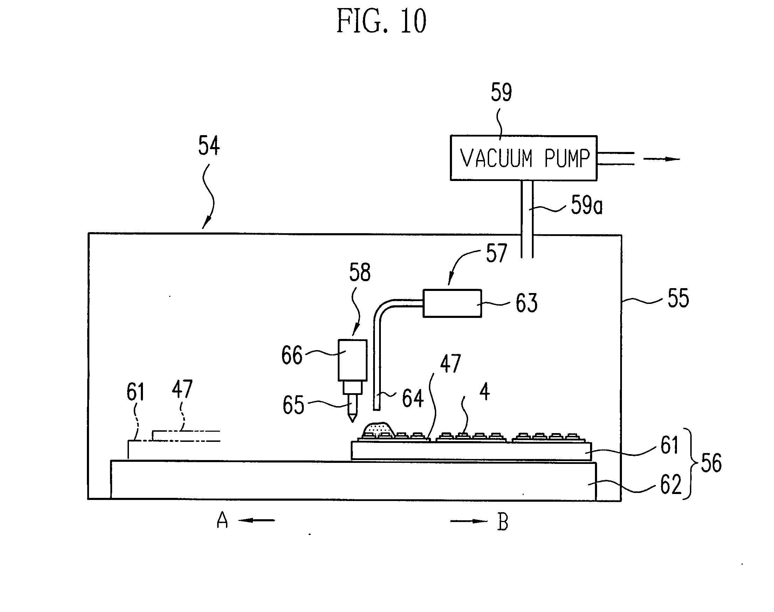

As shown in FIG. 10, a vacuum screen printing machine 54 is used in the sealing step. The vacuum screen printing machine 54 is constituted of an air and pressure tight chamber 55, a horizontally shifting stage 56, a resin supply section 57, a print section 58, and a vacuum pump 59 for increasing and decreasing pressure in the chamber 55.

The horizontally shifting stage section 56 includes a stage 61, on which the circuit assembly board 47 is placed, and a stage shift mechanism 62 that moves the stage 61 horizontally to left and right directions in the drawing. The resin supply section 57 includes a supply tank 63 that contains and supplies the paste of sealing resin 7 and a nozzle 64 for discharging the paste of sealing resin 7 around the circuit assembly board 47. The print section 58 includes a squeegee 65 pressed on the upper face of the circuit assembly board 47 and a squeegee shift mechanism 66 that moves the squeegee 65 in a vertical direction for alignment between the squeegee 65 and the circuit assembly board 47.

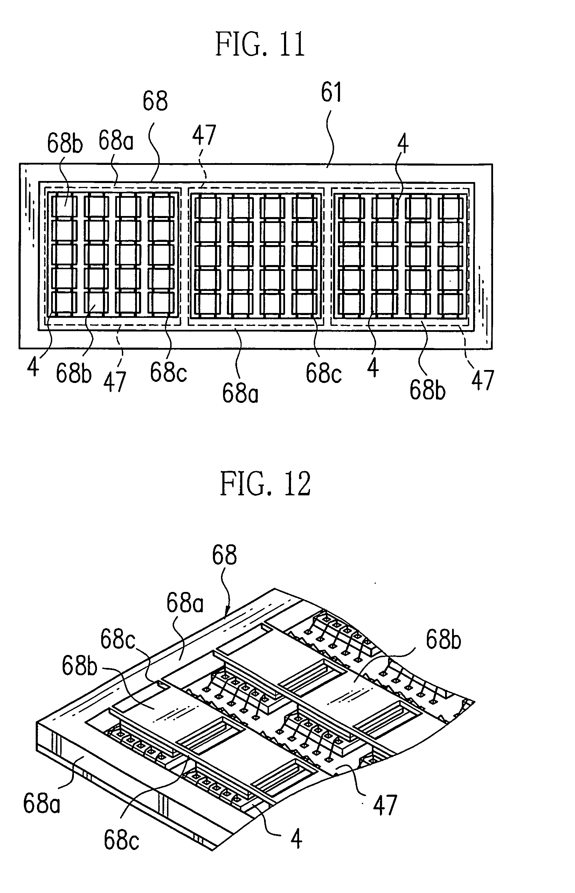

FIG.11 is a overhead view of the stage 61. In the protection step according to the present invention, three circuit assembly boards 47 are set on the stage 61, and covered by a mask 68 that has an outer wall 68a for defining a print area of the sealing resin 7 and mask sections 68b for protection of the upper face of the cover glass 6 of each sensor package 4. Since the upper faces of the cover glasses 6 are almost level with each other on the circuit assembly boards 47 owing to the uniform thickness of the die attach films 51, the mask sections 68b are able to cover the upper face of each cover glass 6 appropriately. Therefore, the sealing resin 7 hardly sticks to the upper faces of the cover glasses 6.

As shown in FIG. 12, each mask section 68b is connected to the adjacent mask sections 68b and, eventually, the outer wall 68a by extremely narrow connection sections 68c. Although the sealing resin 7 is not printed underneath the connection sections 68c, a sealing performance will not be degraded because the connection sections 68c are extremely narrow.

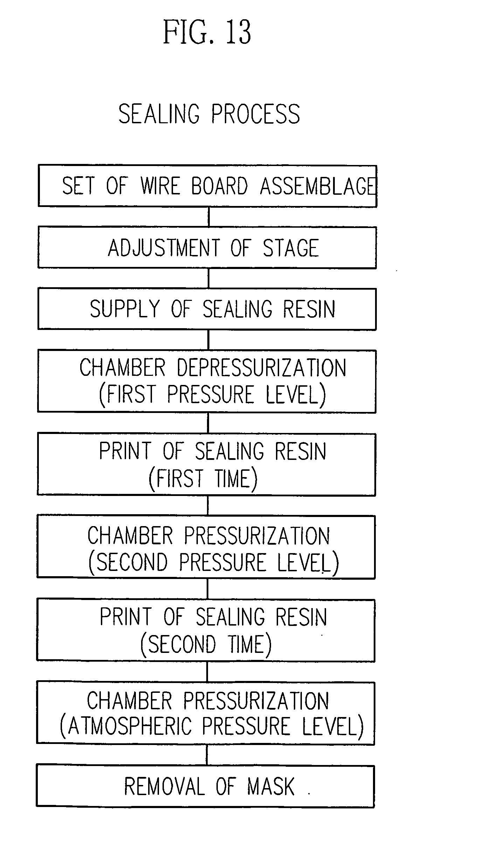

The sealing resin 7 is printed according to the process according to the present invention as shown in the flow chart of FIG.13. Firstly, three circuit assembly boards 47 are set on the stage 61 and tightly fixed thereto by suction. Then, the squeegee 65 is moved by the squeegee shift mechanism 66 in the vertical direction so that it is aligned with respect to the upper face of the circuit assembly board 47. The resin supply section 57 discharges the sealing resin 7 from the nozzle 64 onto the circuit assembly board 47.

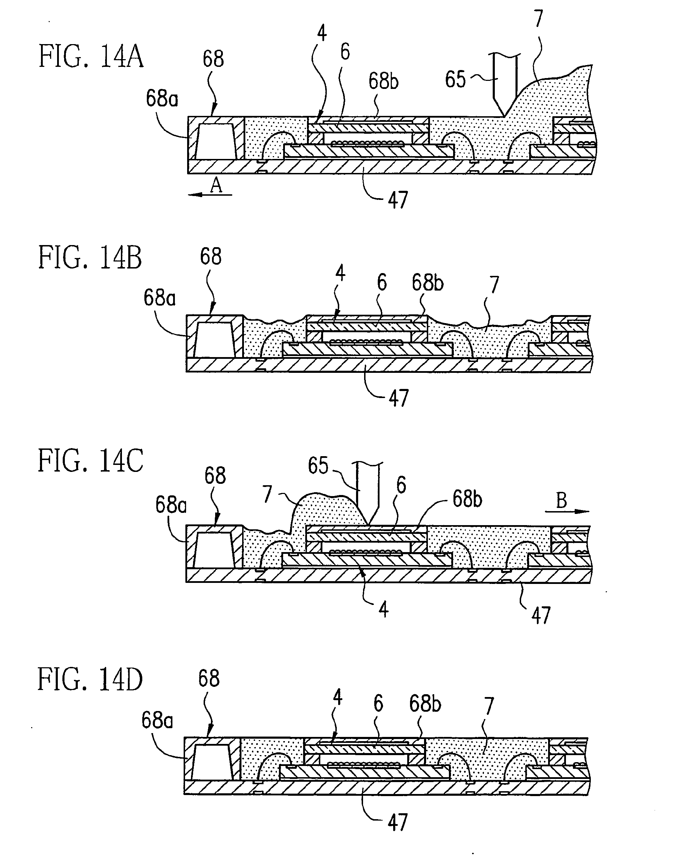

The vacuum pump 59 is activated to release air from the chamber 55 through a pipe 59a to decrease the air pressure to a first pressure level. The stage shift mechanism 56 moves the stage 61 to the left side direction, or "A" direction, in the drawing. Thereby, the sealing resin is filled around the sensor packages 4 by the squeegee 65, as shown in FIG. 14A. Figures 14A - D show process steps according to the present invention.

When the stage 61 reaches the position shown with chain double-dashed lines in FIG.10, a first vacuum screen printing operation is finished. Then, the vacuum pump 59 slightly opens an air intake valve to increase the air pressure inside the chamber 55 to a second pressure level. The second pressure level is lower than the atmospheric pressure level. Even if the sealing resin 7 contains hollows or bubbles after the first vacuum screen printing, change in air pressure between the first and second pressure levels causes the sealing resin 7 to be sucked in such hollows or bubbles, as shown in FIG.14B.

To correct the dented surface of the sealing resin 7 due to the increase to the second air pressure level, the second vacuum screen printing is performed. Similar to the first vacuum screen printing, the resin supply section 57 discharges the sealing resin 7 from the nozzle 64 onto the circuit assembly board 47. The stage shift mechanism 56 moves the stage 61 in "B" direction, and thereby, as shown in FIG.14C, the sealing resin is filled around the sensor packages 4 by the squeegee 65.

The vacuum pump 59 is stopped when the second vacuum screen printing operation is finished, and the air intake valve is fully opened to increase the air pressure inside the chamber 55 to atmospheric pressure level. Meanwhile, the squeegee shift mechanism 66 moves the squeegee 65 upwards to separate the tip of the squeegee from the circuit assembly board 47. Thereby, as shown in FIG.14D, each of the sensor packages 4 is surrounded by the sealing resin 7, whose surface is made flat.

When all the vacuum screen printing operation is completed, the circuit assembly boards 47 are removed from the vacuum screen printing machine 54 and the masks 68 are detached. Immediately after the molding operation, the sealing resin 7 is still under polymerization and unstable in character. Therefore, a subsequent is a post mold curing (PMC) step, in which the circuit- assembly boards 47 are placed in an oven or the like and heated for curing of the sealing resin 7.

The sealing resin would preferably be a thermosetting resin of epoxy, and may have characteristics suitable for the vacuum screen printing such as, for example, a viscosity of 450Pas at normal temperature, a Young's modulus of 25000MPa, and a coefficient of thermal expansion of approximately 12ppm/° C. It is preferable that the first air pressure is no more than 100Pas and the second air pressure is approximately 20000Pas to 90000Pas.

Performed after the sealing is a marking step, in which information such as a manufacturer name, product name, product number, and lot number is printed on the sealing resin 7 with a laser marker.

Following is a singulation step, where the circuit assembly board 47 is separated together with sealing resin 7 into individual sensor packages 4. As shown in FIG.8E, the circuit assembly board 47 is placed on a dicing tape 71 such that the cover glass 6 faces the dicing tape 71. Then, as shown in FIG. 8F, the sealing resin 7 and the circuit assembly board 47 are diced, from the back side, by a dicer into individual sensor packages 4. Thereby, a plurality of the solid state imaging devices 2 can be produced at one time.

In the next packing step, the solid state imaging devices 2 are detached from the dicing tape 71 and individually put on trays by a packing machine or attached to the carrier tapes for shipment. Also, it is possible to ship several solid state imaging devices 2 remained on the dicing tape 71.

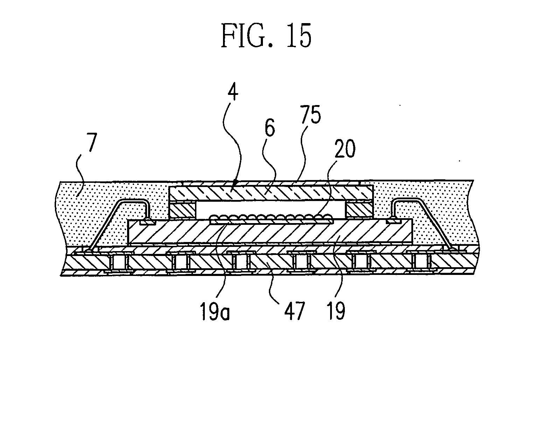

Although the cover glass 6 of each sensor package 4 is protected by the mask section 68b of the mask 68 in the above embodiment, a protection sheet may be used for protection of the upper faces of the cover glasses 6. For example, as shown in FIG.15, the upper face of the cover glass 6 is attached to a protection sheet 75, which has a similar shape to the light receiving surface of the image sensor 19a and is larger than the light receiving surface but smaller than the upper face of the cover glass 6. It is better, in this case, to arrange the protection sheet 75 such that the edge of the protection sheet 75 stays at between the edges of the light receiving surface of the image sensor 19a and the upper face of the cover glass 6. The protection sheets 75 may be attached individually to the cover glasses 6, or attached all together with using the upper mold die 58.

Of importance, if the edge of the protection sheet 75 juts outside the cover glass 6, it will bend and get into the sealing resin 7 in the coating for sealing operation. Such protection sheet 75 will leave a print, e.g. a dent, in the sealing resin 7 when detached from the cover glass 6, and the sealing performance as well as appearance of the sealing resin is degraded. In the present embodiment, however, the edge of the protection sheet 75 stays within the upper face of the cover glass 6, and the foregoing problem will never occurs. In addition, the protection sheet 75 does not impair the performance of image sensor 19a because it is larger than the light receiving surface of the image sensor 19a.

If the protection sheet 75 is employed to protect the upper surface of the cover glass 6, an enclosing frame for the circuit assembly board 47 will be needed to define the coating area of the sealing resin 7. The enclosing frame may be either or both of the outer wall section 68a of the mask 68 and a resin made retaining wall formed around the circuit assembly board 47.

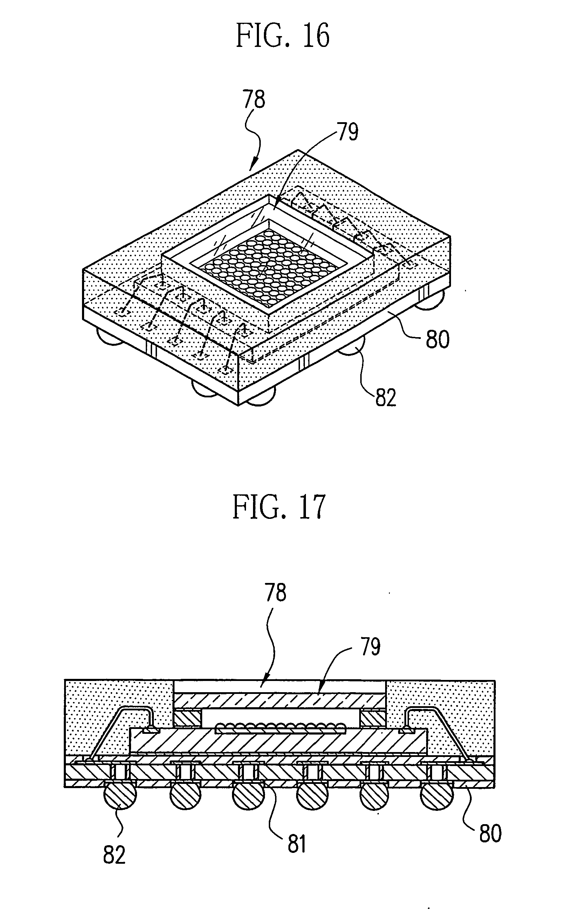

Although the above embodiment is directed to the manufacturing method for the solid state imaging device in an FLGA package, the present invention is applicable to the solid state imaging device in a Fine Pitch Ball Grid Array (FBGA) package which uses solder balls as the external electrodes. As shown in FIG.10 and FIG.17, the solid state imaging device 78 of a second example being useful to understand the present invention is provided with a solder ball 82 on each external conductive pads 81 of a circuit board 80, which is attached to a sensor package 79. The FBGA package is also prevalent in the art, and it is possible to manufacture reliable solid state imaging devices 78 at low cost.

To manufacture the solid state devices 78 in the FBGA packages, solder ball formation process are provided between the marking step and the singulation step, as shown by the flow chart of FIG.15. The solder ball 82 is formed by, for example, a ball mounting method which includes a ball mounting step, a reflow step, and a cleaning step. Initially, in the ball mounting step, flux and solder are applied on the external conductive pads 81. Then the solder balls 82 are disposed by a solder ball mounter on the external conductive pads 81. In the reflow step, the solder is heated and melted by a solder reflow machine to fix the solder balls 82 onto the external conductive pads 81. Finally, the flux is removed using a flux cleaner in the cleaning step.

The aforementioned embodiment and examples are described with the printed circuit board for the circuit assembly board. However, in an example being useful to understand the present invention the circuit assembly board may be either a tape substrate or a lead frame. As is well known, the lead frame is a metal frame provided with die pads for attachment of chips, inner leads to be wire bonded to input/output pads of the chips, and outer leads as the external electrodes. The lead frame goes through the wire bonding step, sealing step, and singulation step after the sensor packages are die bonded to each of the die pads, and consequently the solid state imaging devices are produced.

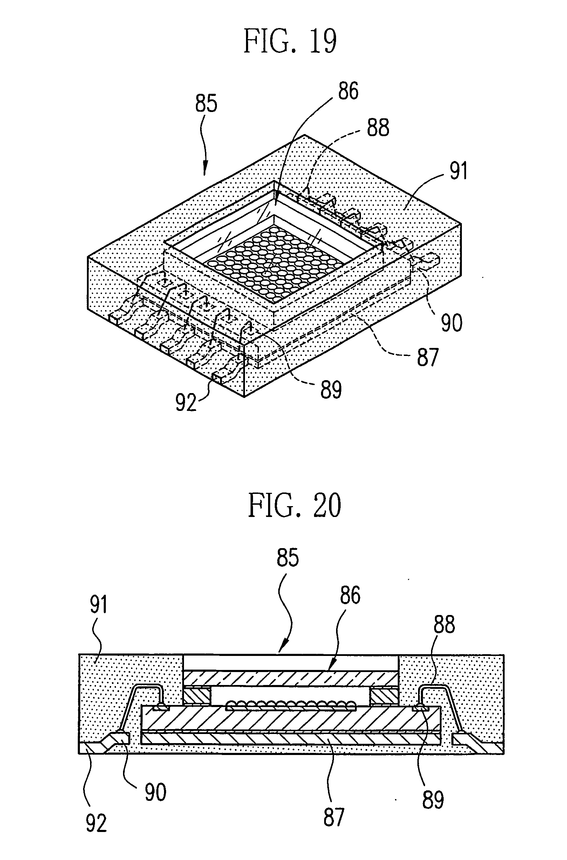

FIG.19 and FIG.20 show a solid state imaging device 85 of a third example being useful to understand the present invention. Made from the lead frame, the solid state imaging device 85 is in a package called "Quad Flat Non-leaded (QFN)". The solid state imaging device 85 is constituted of a die pad 87 to which a sensor package 86 is fixed, inner leads 90 as internal electrodes connected through bonding wires 88 to input/output pads 89 of the sensor package 86, and outer leads 92 as external electrodes exposed at lower side faces of a sealing resin 91. The QFN package is prevalent in the art, and it is possible to manufacture reliable solid state imaging devices 85 at low cost. Although the under surface of the die pad 87 is covered with the sealing resin 91, it may be exposed for better heat radiation of the sensor package 86.

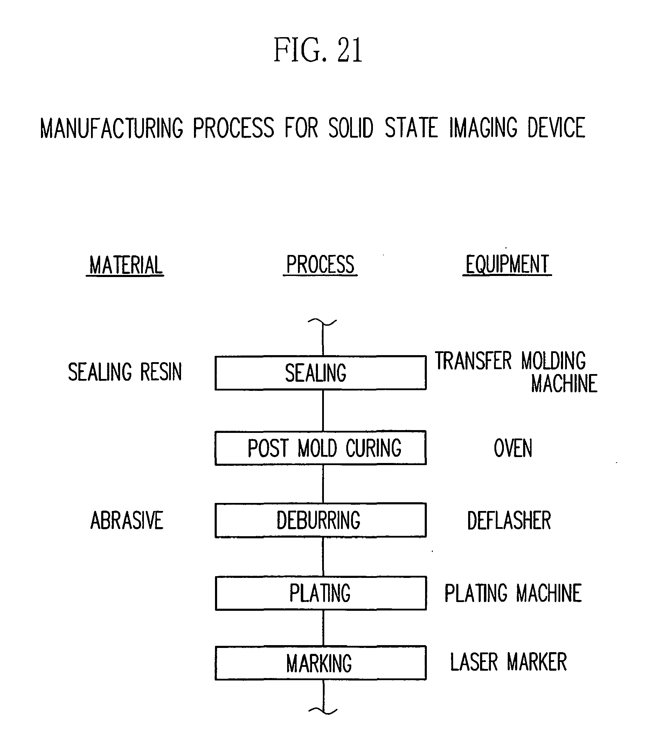

To manufacture the solid state imaging devices 85 in the QFN packages, a deburring step and a plating step are provided between the sealing step and the marking step, as shown by a flow chart of FIG.21. In the deburring step, a deflasher is used to spray abrasives onto the sealing resin 91 so that the outer leads 92 are exposed. The exposed outer leads 92 are then plated in the plating step. The reason to perform the deburring before the marking step is to avoid the possibility for abrasives to damage the marks. It should be noted that the plating step can be omitted if the lead frame is a PD-PPF(Palladium Pre-plated frame).

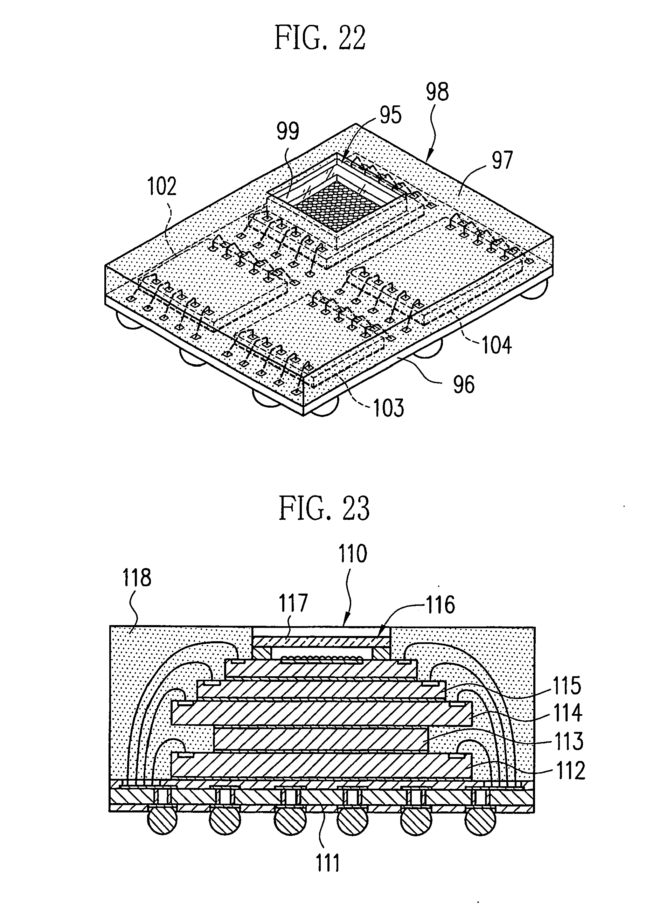

Although the above embodiment and examples are all described with a single package of solid state imaging device that contains the sensor package, the present invention is applicable to a system-in-package (SIP) of solid state imaging device 98 (fourth example being useful to understand the present invention) as shown in FIG. 22. The solid state imaging device 98 is constituted of a sensor package 95 and several cooperating chips, which are all fixed on a circuit board 96 then sealed with a sealing resin 97. With using the SIP solid state imaging device 98, a camera unit can be formed only by attaching an imaging optical system onto a cover glass 99. Therefore, the camera unit can be easily incorporated in various electrical equipments.

The cooperating chips may be, for example, an analog front end (AFE) chip 102 for digitization of the analog image signals from the sensor package 95, a digital signal processor (DSP) chip 103 for image processing of digitized image data, and a power supply chip 104.

In addition, it is possible to stack a power supply chip 112, a spacer 113, a DSP chip 114, an AFE chip 115, and sensor package 116 on a circuit board 111 in this order to have a stacked system-in-package such as a solid state imaging device 110 (fifth in an example being useful to understand the present invention) in FIG.23. In this case, the stack should be sealed with a sealing resin 118 such that the upper face of the cover glass 117 of the sensor package 116 is exposed from the resin.

To manufacture the solid state imaging device 98 or 110 in SIP, the cooperating chips are treated together with the sensor package 95 or 116 in both the die bonding step and wire bonding step. In the sealing step, all the elements are sealed with the sealing resin 97 or 118 except the upper face of the cover glass 99 or 117. Further, in the singulation step, individual circuit boards 96 or 111 are cut out such that each of them has a group of chips for a single system.

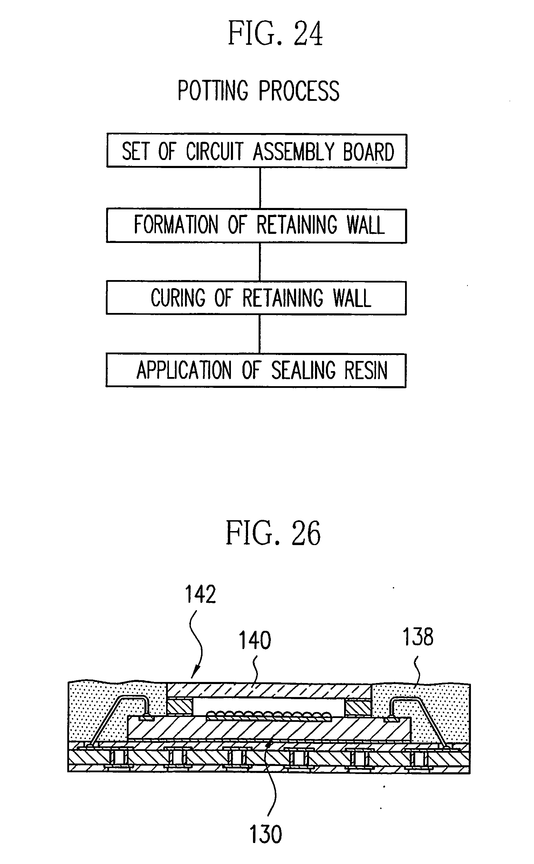

The sealing resin, in the above embodiment and examples, is applied through the vacuum screen printing operation. However, the vacuum screen printing operation requires a dedicated mask member, and results to increase the cost in a small lot production. An alternative to the vacuum screen printing may be a potting operation. With the potting operation, the procedure for manufacturing the solid state imaging device is almost the same as the one with the vacuum screen printing operation as shown in FIG.3, except that the potting process shown in FIG.24 replaces the vacuum screen printing process. Hereinafter, the detailed explanations for the structures already described will be omitted.

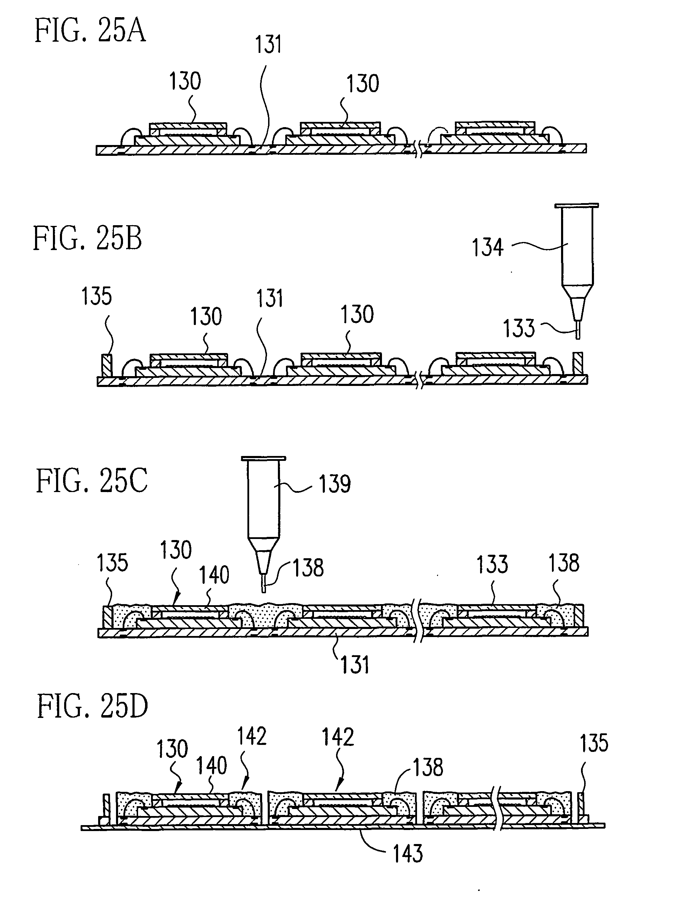

As shown in FIG.25A, the manufacturing procedure begins by fixing a circuit assembly board 131, which contains a numbers of sensor packages 130 completed with the wire bonding process, onto a work table of a potting machine. Then, as shown in FIG.25B, a dam injection syringe 134 containing a dam material 134 is placed above the outer periphery of the circuit assembly board 131, and moved along the outer periphery with the dam material 133 injected, so that a mound of the dam material forms a retaining wall 135 around the circuit assembly board 131. The retaining wall 135 defines the coating area of the sealing resin. Preferably, the sealing resin has high viscosity, such as approximately 500Pas , so as not to push away the dam material 133 and break the retaining wall 135.

Next, as shown in FIG.25C, a sealing syringe 139 containing liquid of sealing resin 138 is placed above the circuit assembly board 131 and moved between the sensor packages 130 with the sealing resin 138 injected thereto. The sealing resin 138 thereby seals the sensor packages 130 except the upper surface of each cover glass 140.

As in the above embodiment and examples with vacuum screen printing, a subsequent is the post mold curing process, in which the sealing resin 138 and the retaining wall 135 are heated for curing. They are cured at the same time because the retaining wall, if cured previously, may cause warpage of the circuit assembly board 135 or at least increases the number of process.

Finally, as shown in FIG.25D, a dicing tape 131 is attached on the under surface of the circuit assembly board 131, which is then diced together with the sealing resin 138 into individual sensor packages 130. Thereby, a solid state imaging device 142 shown in FIG.26 is manufactured. Although the sealing resin 138 coated through the potting operation may have an uneven upper surface, it does not cause any functional problem to the solid state imaging device 142.

In the above example, the dam material is made from the same raw material as the sealing resin. However, the dam material can be made from any of those that are compatible in thermal expansion coefficient and the like with the sealing resin. Additionally, the retaining wall can be cured before the coating of the sealing resin if the dam material has almost the same thermal expansion coefficient as the circuit assembly board and the increase in the number of process is agreeable. The resin seal through the above potting operation is applicable to any of the solid state imaging devices in the second to fifth examples.

The semiconductor devices, such as the solid state imaging device, should have high reliability enough to ensure a certain level of function and performance of the apparatuses that they belong to, over a predetermined period at the end users. Therefore, the semiconductor devices are generally checked in a standardized reliability test. There are some standards of measure for the semiconductor devices, and a notable one is the JEDEC (Joint Electron Device Engineering Council) standard. The JEDEC semiconductor standard specifies a reliable test for the semiconductor devices.

The reliable test of the JEDEC standard consists of two parts, a pre-condition test where the semiconductor device is put under stress that it would get before or at the time of installation in the various apparatuses and main test where the semiconductor device is put under a high stress that the device will get over a long duration in practical use. Of the two, the pre-condition test divides into 3 levels according to the amount of stress. The following are the conditions for the pre-condition test and the main test.

Reliability test conditions on the JEDEC standard

### 1. pre-condition test

(1) high temperature high humidity storage condition
   level 1: 85°C, 85% humidity, 168 hours
   level 2: 85°C, 60% humidity, 168 hours
   level 3: 30°C, 60% humidity, 192 hours
(2) reflow condition
   pre-heat: 160°C, 60 seconds
   main heat: 260°C, 20 seconds

### 2. main test

(1) high temperature high humidity storage test: 85°C, 85% humidity, 1000 hours
(2) temperature cycle test: 85°C ↔ -40°C, 1000 cycles

The solid state imaging device 2, made according to the first embodiment of the present invention, did not pass the above JEDEC reliability test because of a series of problems, which are the steam explosion of the moisture trapped in the sealing resin 7, the resulting cracks on the sealing resin 7 or the boundary of the sealing resin 7 and the sensor package 4 to peel off the sealing resin 7 from the sensor package 4 and the circuit board 3, and sequent separation of the bonding wires 5 from the internal conductive pads 12 or the input/output pads 21 to make the device inoperative.

Also, there is a problem that the trapped moisture dissolves ionic impurities out from the sealing resin, and an electrochemical decomposition reaction is thereby stimulated to possibly corrode the aluminum-made input/output pads.

Furthermore, when the sealing resin 7 peels off, the spacer 22 and the cover glass 6 also come off from the imaging chip 19, along with the sealing resin 7. Consequently, the cavity surrounded by the imaging chip 19, the spacer 22, and the cover glass 6 fails to be sealed properly, and moisture enters inside the cavity to cause fog on the cover glass 6 and electrical malfunctions of the image sensor 19a.

In an example being useful to understand the present invention, the undermentioned various modifications are made to the structure, the several conditions, and the sealing resin in order to obtain the solid state imaging device able to pass the reliability test. Note that detailed explanation is omitted for the structures already mentioned in the above embodiments.

Based on a presumption that one of the reasons for peeling off of the sealing resin from the sensor package would be weakness in adhesion force between the two, a new structure is designed to improve the adhesion force.

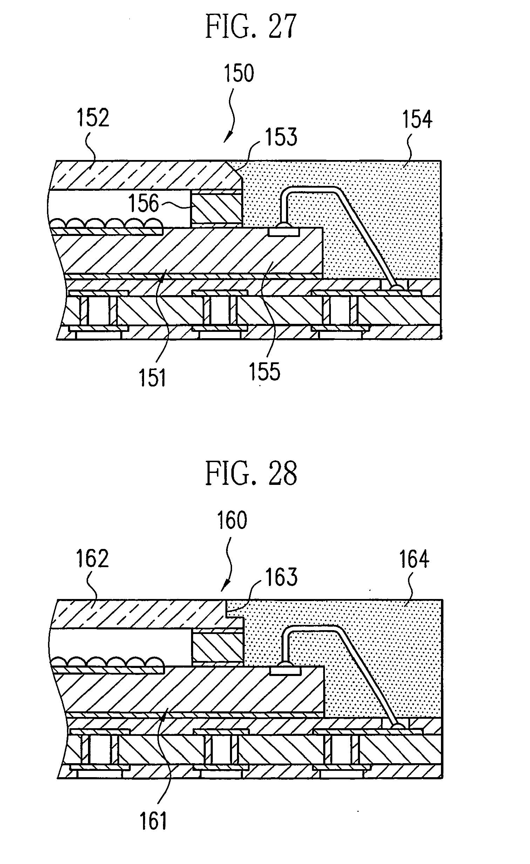

A solid state imaging device 150, shown in FIG.27, is provided with a chamfered section 153 running along the peripheral edge of a cover glass 152 of a sensor package 151. Since the chamfered section 153 operates to broaden the contact area of sealing resin 154 and the sensor package 151, the adhesion force increases on the sealing resin 154 to produce an anchor effect that prevents the peeling off of the sealing resin 154 from the sensor package 151. In addition, even when the cavity between the imaging chip 155, the spacer 156, and the cover glass 152 gets high temperature to increase the pressure therein, the reaction force that acts on cover glass 152 serves to enhance the sealing function inside the cavity.

For the same purpose, a solid state imaging device 160, in FIG. 28, is provided with a step section 163 running along the peripheral edge of a cover glass 162 of a sensor package 161, so that the contact area to sealing resin 164 is broadened. The chamfered section 153 and the step section 163 have no negative effect on the image sensor 19a as long as they stay within the width of the spacer 22.

The chamfered section 153 and the step section 163 can be formed by using a slicer or a dicer, in the dicing operation to the glass substrate 28 and the silicon wafer 37, as shown in FIGS.6D and 6E. They do not require a significant increase in the operation step, but are employed at low cost.

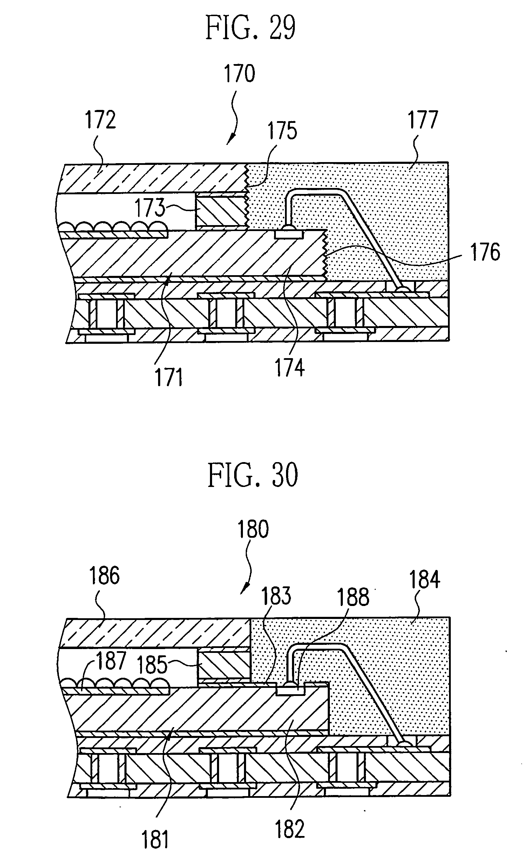

Although the above examples are both to obtain the anchor effect at the edge of the cover glass, a solid state imaging device 170, as shown in FIG. 29, obtains the anchor effect through rough surfaces 175 and 176, formed over all the side faces of a cover glass 172 of a sensor package 171, a spacer 173, and an imaging chip 174. The rough surfaces 175 and 176 are easily shaped in an etching process or the like, which may be introduced after the dicing operation, as shown in FIG.6E, to the glass substrate 28 and the silicon wafer 37.

As another method for preventing the peeling off of the sealing resin, a high adhesion film may be provided over the outer side faces of the sensor package to ensure tight contact with the sealing resin. For example, as a solid state imaging device 180 in FIG.30, an imaging chip 182 of the sensor package 181 may be provided on the upper surface with a polyimide film 183, low defect density material. This film allows tight contact of the sealing resin 184 to the imaging chip 182, and the adhesion force increases on the sealing resin 184 to prevent the peeling off. The imaging chip 182 and a spacer 185 also make tight contact to each other, the two will hardly separate.

The polyimide film 183 can be formed in the process of, for example, forming the image sensor 187 and the input/output pads 188 in the silicone wafer 37. Conveniently, the polyimide film 183 can be used as a passivation film in the plasma etching process. Employed with the aforesaid rough surface 175, the polyimide film 183 serves to protect the upper surface of the imaging chip 182 when the rough surface is shaped by the plasma etching on the side faces of the cover glass 186, the spacer 185, and the imaging chip 182.

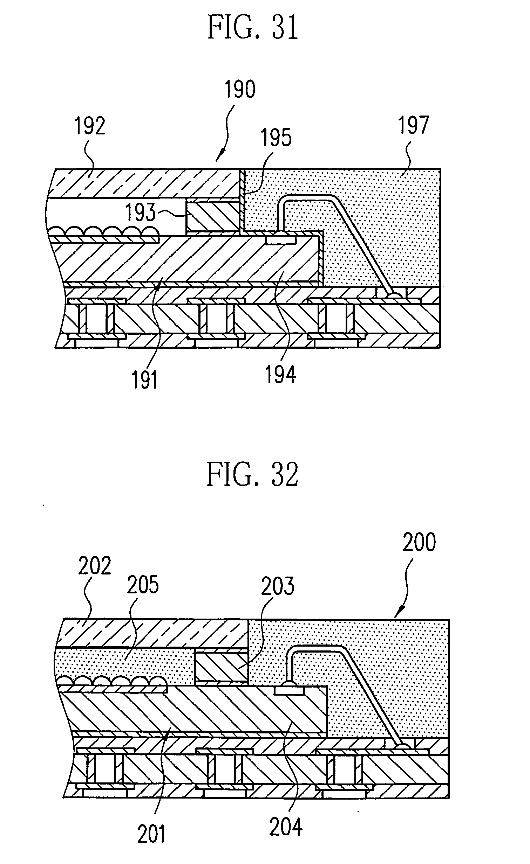

As means to enhance the sealing function for the cavity containing the image sensor, a moisture penetration preventive film can be used. As a solid state imaging device 190 in FIG.31, a nitride thin film 195 is prepared by vapor deposition on the outer side faces of all a cover glass 192 for a sensor package 191, a spacer 193, and an imaging chip 194. Since the thin films operate to increase the adhesion to the sealing resin 197 and, then, the adhesion force of the sealing resin 197. Preferably, the vapor deposition of the nitride film 195 is conducted after the sensor package 4 is die-bonded onto the circuit assembly board 47 and the input/output pads 21 are wire-bonded to the inner conductive pads 12 of the circuit assembly board 47, as shown in FIG.8C In reality, the imaging chip 194 has already had a nitride film formed in the coating process of the silicone wafer 37, and an additional nitride film will be deposited on top of that film.

The nitride thin film and the polyimide film are also effective protection against the steam explosion and the resulting cracks or the peeling off because they encourage the moisture prevention and the tight contact of the elements, blocking the moisture penetrating through the gaps between the sensor package and the circuit board.

One of the reasons that cause the spacer to peel off from the imaging chip seems the stress on the adhesion areas caused by the thermal expansion of the air in the cavity surrounded by the imaging chip, the spacer, and the cover glass. To avoid this situation, the cavity that encloses the image sensor may form a vacuum. Alternatively, as a solid state imaging device 200 in FIG.32, the cavity between a cover glass 202 of a sensor package 201, a spacer 203, and an imaging chip 204 may be filled with an inactive gas 205 such as N2 gas. To form a vacuum inside the cavity or fill the cavity with the inactive gas 205, the silicon wafer 37 and the glass substrate 28 are placed in a vacuum or gas-filled chamber and attached together as shown in FIG. 6B.

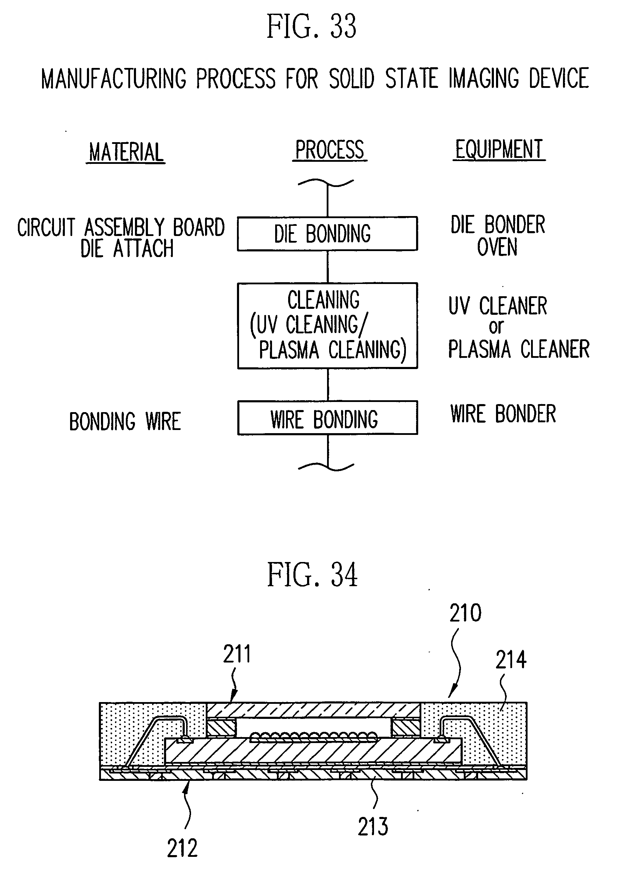

Although the peeling off of the sealing resin is prevented by the additional structures in the above embodiments, the same effect may be obtained by improving the adhesion of the nitride film previously provided on the upper surface of the imaging chip. The adhesion can be improved through a UV cleaning machine or a plasma cleaning machine. The UV cleaning machine removes organic impurities from the nitride film and improves wettability thereof, and the adhesion of the sealing resin is therefore improved. The plasma cleaning machine acts to improve wire bonding property to the input/output pads, and the increased bonding force is produced between the input/output pads and the bonding wires. As shown in FIG. 33, the UV cleaning machine or the plasma cleaning machine may replace the O₂ asher in the cleaning step of the first embodiment.

The moisture directly penetrates the surface of the sealing resin, and at the same time, it penetrates through the circuit board into the sealing resin. Since the circuit board has a relatively large dimension, it can serve a lot to keep off the moisture from the sealing resin. According to this embodiment shown in FIG. 34, therefore, a solid state imaging device 210 incorporates a tape substrate 211, as the circuit board to which a sensor package 214 is attached. The tape substrate 211 includes a base 212 made of a super heat resistant polyimide film. Since the super heat resistant polyimide film drains moisture from the sealing resin 213, the possibility of the steam explosion in the sealing resin 213 is reduced. Being thinner than the glass epoxy substrates, the tape substrate 211 is also able to reduce the thickness of the solid state imaging device 210.

The super heat resistant polyimide films can be easily obtained, and one known is Kapton (registered trademark) film (product name: E.I. du Pont de Nemours & Company).

Although the sealing resin is an epoxy resin in the above embodiment, another resin with higher adhesion may be used so that the sealing resin does not peel off from the sensor package and the circuit board. The resin with high adhesion will be, for example, bisphenol type epoxy resin. Preferably, this kind of high adhesion resin is combined with an amine or polyamine curative agent.

From the view point of the screen printing function, potting function, and the anti-void function, the sealing resin may preferably have a viscosity of no more than 50Pas at the time of coating. For example, if the sealing resin has the viscosity of approximately 450Pas at normal temperature, it should be heated to around 40°C and has the viscosity of 50Pa at the time of coating. Alternatively used is low viscosity sealing resin with the viscosity of approximately 50Pa at normal temperature. In this case, the raw material may be optimized in viscosity by adding a solvent thereto.

It is also preferable to use the sealing resin with a glass transition temperature (Tg) of no less than 150° C to create an improved temperature cycle.

Still another cause of the cracks and the peeling off of the sealing resin 7 is thermal stress produced between the sealing resin, the sensor package, and the circuit board. In the first embodiment, the sealing resin (epoxy resin) 7 has a thermal expansion coefficient (α) of approximately 50ppm/° C. The imaging chip 19 and the spacer 22 both made from silicon have the thermal expansion coefficient of 3ppm/° C, and the cover glass 6 has the thermal expansion coefficient of 6ppm/°C, then the circuit board 3 made from glass epoxy has the thermal expansion coefficient of 13 to 17ppm/°C. Such difference in thermal expansion coefficient leads to produce the thermal stress during the molding operation; the reflowing operation, the PMC operation, and the temperature cycle in actual use, and the sealing resin 7 sometimes gets bent or twisted or cracked. To avoid this problem, it is preferable that the sealing resin 7 has the thermal expansion coefficient of no more than 13ppm/°C.

Also, to reduce the thermal stress, it is preferable that the sealing resin has a flexural modulus of no more than 28GPa, and a mold shrinkage factor of no more than 0.12%. In addition, the sealing resin should have a hardness of 90 shore D and above in order to ensure a proper level of strength in the solid state imaging device to prevent the deformation thereof.

The spacer and the cover glass can possibly peel off from the imaging chip if the adhesive that bonds the spacer reaches Tg (the glass transition temperature) in the PMC operation. It is therefore preferable to adjust Tg of the adhesive to no less than the PMC temperature. Nonetheless, the adhesive agent may have the transition temperature lower than the PMC temperature if the sealing resin has low thermal expansion coefficient and therefore gives less thermal stress on the adhesive agent at high temperature.

The thermal stress, due to the difference in thermal expansion coefficient, is also produced between the sensor package and the circuit board , causing the cracks and the peeling off of the sealing resin. Here, the circuit board made from the glass epoxy has the thermal expansion coefficient of 13 to 17ppm/° C, while the circuit board made of the super heat resistant polyimide film has the thermal expansion coefficient of 16 to 60ppm/°C. Compared to the imaging chip with the thermal expansion coefficient of 3ppm/°C, there is a considerable difference.

To avoid the above problem, it is preferable to use a die attach film, which has the glass transition temperature lower than the PMC temperature. The die attach film absorbs bend or twist of the imaging chip and the circuit board in the PMC operation, and prevents the cracks and the peeling off of the sealing resin. Additionally, it is preferable that the die attach film has, for example, Tg of 50° C to 80° C and α of 80 to 100ppm/°C, so that it can reach the glass transition temperature in the beginning of the PMC operation.

It is also preferable to use the sealing resin with a water absorption coefficient of no more than 0.3% by weight (saturated vapor pressure test: 20 hours), in order to prevent the moisture absorption of the sealing resin 7 that may cause the steam explosion. Furthermore, when the input/output pads of the sensor package need to be protected from corrosion, the sealing resin should have the water absorption coefficient of no more than 0.15% by weight.

The water absorption coefficient of the sealing resin 7 can be reduced by increasing a ratio of the filler material, other than using the resin with low water absorption coefficient. For example, the sealing resin 7 in the first example contains a filler material, such as silica, which occupies 73% of the whole, but there shows no improvement in the water absorption coefficient of the sealing resin. Then, a solid state imaging device is made using sealing resin with the increased ratio of the filler material to 80% and above. This solid state imaging device had less cracks and peeling under the JEDEC reliability test. It is therefore preferable to use sealing resin with the ratio of the filler material of no less than 80%.

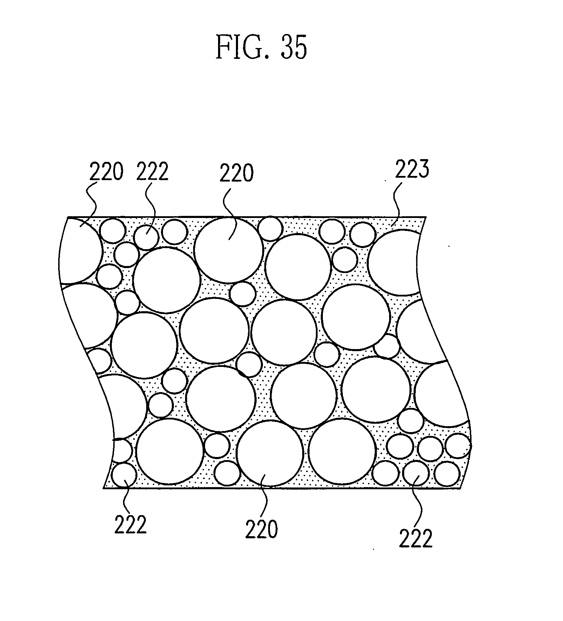

To increase the ratio of the filler material, the sealing resin may be mixed with filler materials with two different sizes, coarse grains (e.g. diameter 55 *µ*m) and fine grains (e.g. diameter 20 *µ*m). As shown in FIG. 35, fine grains 222 fit in the space between coarse grains 220, and thus the ratio of the filler material becomes 80% and above in sealing resin 223.

Although the increase of the filler ratio leads to increase the viscosity of the sealing resin, such effect can be dealt by optimizing the raw material of the sealing resin. It is thereby possible to obtain the low viscosity sealing resin suitable for the screen printing operation and the potting operation.

Also, it is preferable to use low-halogen and low-alkali metal sealing resin (e.g. no more than 10 ppm). Such sealing resin releases less ionic impurities, and serves to prevent the corrosion of the input/output pads.

In order to prevent the cracks resulted from the difference in thermal expansion, the dam material used in the potting process may preferably be the same type of resin as the sealing resin, and have the thermal expansion coefficient of no more than 13 ppm/° C, and the viscosity of approximately 500Pas.

The aforesaid various modifications prevent the cracks and the peeling off of the sealing resin, and improve the sealing function for the cavity containing the image sensor as well. In addition, they can prevent the removal of the bonding wires from the pads, and contribute to prevent malfunctions of the solid state imaging device. For example, controlling the sealing resin to have the ratio of filler material of no less than 80% and the thermal expansion coefficient of no more than 20ppm/° C leads the solid state imaging device to survive 500 hours per 1000 cycles in the high temperature high humidity storage test and the temperature cycle test. Also, using the circuit board of the super heat resistant polyimide film enables to meet level 1 precondition of the JEDEC reliability test.

It is possible to use the aforesaid various modifications separately or in combination as appropriate. Although these modifications are explained with the solid state imaging device made according to the first example, it is sure that these modifications are applied to any of the solid state imaging devices made according to the second to fifth examples.

Although the above embodiment and examples are described with the solid state imaging devices of CCD type, the present invention is applicable to the manufacture of solid state imaging devices of CMOS type or the like. Also, the present invention is applicable to the manufacture of solid state imaging devices in various packages other than the FLGA, FBGA, QFN, and SIP.

### Industrial Applicability

The solid state imaging device made according to the present invention can be applied to digital cameras, mobile phones, electronic endoscopes, and some such.

## Claims

1. A method of manufacturing solid state imaging devices comprising:
a die bonding step for adhering sensor packages (4) to each of a plurality of bonding areas (48) formed on a circuit assembly board (47), each of said sensor packages having an imaging chip (19) provided with an image sensor (19a) and input/output pads (21) and a translucent cover (6) attached to said imaging chip for sealing said image sensor;
a wire bonding step for connecting said input/output pads to internal electrodes (12) with using bonding wire (5), said internal electrodes being provided in said circuit assembly board to correspond to said sensor packages;
a coating for sealing step for coating sealing resin (7) onto said circuit assembly board to seal peripheries of said sensor packages after the wire bording step; and
a singulation step for cutting said circuit assembly board together with said sealing resin into individual sensor packages, **characterized in that** said coating for sealing step includes:
a protection step for covering upper face of said cover with a detachable mask (68) after said wire bonding step; and
a printing step for printing sealing resin onto said circuit assembly board by a vacuum screen printing technique after said protection step,
detaching said mask after the printing step; and **in that** the method comprises
a mold curing step for heating to cure said sealing resin prior to the singulation step.

2. A method as described in claim 1, wherein said mask is a protection sheet which is larger than said image sensor but smaller than an upper face of said cover, said protection sheet is attached to said upper face of said cover such that edges of said protection sheet stay between edges of said image sensor and said upper face of said cover.

3. A method as described in claim 2, wherein said mask includes an outer wall which surrounds said circuit assembly board to define a print area of said sealing resin.

4. A method as described in claim 2, wherein said sealing step includes:
a first printing step for screen printing said sealing resin around said sensor packages under first air pressure less than atmospheric pressure; and
a second printing step for screen printing said sealing resin again around said sensor packages under second air pressure greater than said first air pressure but less than atmospheric pressure.

5. A method as described in claim 4, wherein said first air pressure is no more than 100 Pa while said second air pressure is approximately 20.000 Pa to 90.000 Pa.

6. A method as described in claim 1, wherein said cover is attached to said imaging chip by an adhesive agent, having a glass transition temperature higher than a heat curing temperature in said mold curing step.

## Patentansprüche

1. Verfahren zum Fertigen von Festkörper-Bildgebungsbauelementen, umfassend:
einen Die-Bond-Schritt zum Anbringen von Sensorgehäusen (4) an jedem von einer Mehrzahl von Bondflächen (48), die auf einer Schaltungsplatine (47) ausgebildet sind, wobei jedes der Sensorgehäuse ein Bildgebungschip (19) mit einem Bildsensor (19a) und Eingangs-/Ausgangs-Pads (21) und eine an dem Bildgebungschip zum Abdichten des Bildsensors angebrachte durchscheinende Abdeckung aufweist;
einen Draht-Bond-Schritt zum Verbinden der Eingangs-/Ausgangs-Pads mit internen Elektroden (12) unter Verwendung von Bonddrähten (5), wobei die internen Elektroden in der Schaltungsplatine entsprechend den Sensorgehäusen vorgesehen sind;
einen Abdichtungs-Überzugschritt zum Aufbringen von Abdichtungsharz (7) auf die Schaltungsplatine, um Peripherien der Sensorgehäuse nach dem Draht-Bond-Schritt abzudichten; und
einen Vereinzelungsschritt zum Schneiden der Schaltungsplatine zusammen mit dem Abdichtungsharz in individuelle Sensorgehäuse, **dadurch gekennzeichnet, dass** der Abdichtungs-Überzugschritt beinhaltet:
einen Schutzschritt zum Überziehen der Oberseite des Überzugs mit einer lösbaren Maske (68) im Anschluss an den Draht-Bond-Schritt; und einen Druckschritt zum Aufdrucken von Abdichtungsharz auf die Schaltungsplatine mit Hilfe eines Vakuum-Siebdruckverfahrens im Anschluss an den Schutzschritt,
Lösen der Maske nach dem Druckschritt; und
dass das Verfahren einen Form-Aushärtschritt zum Erhitzen des Abdichtungsharzes zwecks Aushärtung vor dem Vereinzelungsschritt umfasst.

2. Verfahren nach Anspruch 1, bei dem die Maske ein Schutz-Flachstück ist, welches größer ist als der Bildsensor, jedoch kleiner als eine Oberseite des Überzugs, das Schutz-Flachstück an der Oberseite des Überzugs derart angebracht ist, dass Kanten des Schutz-Flachstücks zwischen Kanten des Bildsensors und der Oberseite des Überzugs verbleiben.

3. Verfahren nach Anspruch 2, bei dem die Maske eine Außenwand enthält, welche die Schaltungsplatine umgibt, um einen Druckbereich für das Abdichtungsharz zu definieren.

4. Verfahren nach Anspruch 2, bei dem der Abdichtungsschritt beinhaltet:
einen ersten Druckschritt zum Siebdrucken des Abdichtungsharzes um die Sensorgehäuse herum unter einem ersten, unter dem atmosphärischen Druck liegenden Luftdruck; und
einen zweiten Druckschritt zum Siebdrucken des Abdichtungsharzes erneut um die Sensorgehäuse herum unter einem zweiten Luftdruck, der größer als der erste Luftdruck, jedoch kleiner als der atmosphärische Druck ist.

5. Verfahren nach Anspruch 4, bei dem der erste Luftdruck nicht mehr als 100 Pa beträgt, während der zweite Luftdruck etwa 20.000 Pa bis 90.000 Pa beträgt.

6. Verfahren nach Anspruch 1, bei dem die Abdeckung an dem Bildgebungschip mit Hilfe eines Klebstoffs angebracht wird, der eine Glasübergangstemperatur aufweist, die höher ist als die Wärme-Aushärttemperatur in dem Form-Aushärtungsschritt.

## Revendications

1. Procédé de fabrication de dispositifs de formation d'image à semiconducteurs comprenant :
une étape de liaison de puce pour faire adhérer des boîtiers de capteur (4) à chacune d'une pluralité de zones de liaison (48) formées sur une carte d'assemblage de circuits (47) ; chacun desdits boîtiers de capteur comportant un composant de formation d'image (19) pourvu d'un capteur d'image (19a) et de pastilles d'entrée/sortie (21) et un capot translucide (6) fixé au dit composant de formation d'image pour enfermer hermétiquement ledit capteur d'image ;
une étape de liaison par fils pour connecter lesdites pastilles d'entrée/sortie à des électrodes internes (12) en utilisant des fils de liaison (5), lesdites électrodes internes étant prévues dans ladite carte d'assemblage de circuits de manière à correspondre auxdits boîtiers de capteur ;
une étape de revêtement à des fins d'étanchéité pour déposer une résine d'étanchéité (7) sur ladite carte d'assemblage de circuits pour fermer hermétiquement les périphéries desdits boîtiers de capteur après l'étape de liaison par fils ; et
une étape de séparation pour découper ladite carte d'assemblage de circuits avec ladite résine d'étanchéité en boîtiers de capteur individuels, **caractérisé en ce que** ladite étape de revêtement à des fins d'étanchéité comprend :
une étape de protection pour recouvrir la face supérieure dudit capot d'un masque détachable (68) après ladite étape de liaison par fils ; et
une étape d'impression pour imprimer une résine d'étanchéité sur ladite carte d'assemblage de circuits par une technique de sérigraphie sous vide après ladite étape de protection,
détachant ledit masque après l'étape d'impression ; et **en ce que** le procédé comprend :
une étape de cuisson dans un moule pour chauffer pour cuire ladite résine d'étanchéité avant l'étape de séparation.

2. Procédé selon la revendication 1, dans lequel ledit masque est une feuille de protection qui est plus grande que ledit capteur d'image, mais plus petite qu'une face supérieure dudit capot, ladite feuille de protection est fixée à ladite face supérieure dudit capot de sorte que les bords de ladite feuille de protection restent entre les bords dudit capteur d'image et ladite face supérieure dudit capot.

3. Procédé selon la revendication 2, dans lequel ledit masque comprend une paroi extérieure qui entoure ladite carte d'assemblage de circuits pour définir une zone d'impression de ladite résine d'étanchéité.

4. Procédé selon la revendication 2, dans lequel ladite étape de fermeture étanche comprend :
une première étape d'impression pour sérigraphier ladite résine d'étanchéité autour desdits boîtiers de capteur sous une première pression d'air inférieure à la pression atmosphérique ; et
une deuxième étape d'impression pour sérigraphier de nouveau ladite résine d'étanchéité autour desdits boîtiers de capteur sous une deuxième pression d'air supérieure à ladite première pression d'air, mais inférieure à la pression atmosphérique.

5. Procédé selon la revendication 4, dans lequel ladite première pression d'air n'est pas supérieure à 100 Pa, tandis que ladite deuxième pression d'air est approximativement de 20.000 Pa à 90.000 Pa.

6. Procédé selon la revendication 1, dans lequel ledit capot est fixé au dit composant de formation d1mage par un agent adhésif, ayant une température de transition vitreuse supérieure à la température de cuisson thermique à ladite étape de cuisson dans un moule.
